# EUROPÄISCHE PATENTSCHRIFT

(11) **EP 1 232 225 B1**
(45) Veröffentlichungstag und Bekanntmachung des Hinweises auf die Patenterteilung: **01.12.2004**
(21) Anmeldenummer: 00972879.1
(22) Anmeldetag: 28.10.2000
(51) Int. Cl.: C09K 11/06, H05B 33/14, C08G 61/02

(54) **SUBSTITUIERTE POLY(ARYLENVINYLENE), VERFAHREN ZUR HERSTELLUNG UND DEREN VERWENDUNG IN ELEKTROLUMINESZENZVORRICHTUNGEN**
SUBSTITUTED POLY(ARYLENE VINYLENES), METHOD FOR THE PRODUCTION THEREOF AND THEIR USE IN ELECTROLUMINESCENT DEVICES
POLY(ARYLENE-VINYLENES) SUBSTITUES, ET PROCEDE DE PREPARATION ET D'UTILISATION DESDITES SUBSTANCES DANS DES DISPOSITIFS ELECTROLUMINESCENTS

(30) Priorität: 09.11.1999 DE 19953806
(43) Veröffentlichungstag der Anmeldung: 21.08.2002
(73) Patentinhaber: Covion Organic Semiconductors GmbH, 65926 Frankfurt (DE)
(72) Erfinder: SPREITZER, Hubert, 68519 Viernheim (DE); BECKER, Heinrich, 61479 Glashütten (DE); STÖSSEL, Philipp, 65929 Frankfurt (DE)
(86) Internationale Anmeldenummer: PCT/EP2000/010645
(87) Internationale Veröffentlichungsnummer: WO 2001/034722

(56) Entgegenhaltungen:
- WO-A-98/27136
- WO-A-99/21936
- WO-A-99/24526
- US-A- 5 558 904
- US-A- 5 817 430
- PATENT ABSTRACTS OF JAPAN vol. 1999, no. 09, 30. Juli 1999 (1999-07-30) & JP 11 097175 A (FUJI PHOTO FILM CO LTD), 9. April 1999 (1999-04-09) in der Anmeldung erwähnt

## Beschreibung

Es besteht ein hoher industrieller Bedarf an großflächigen Festkörper-Lichtquellen für eine Reihe von Anwendungen, überwiegend im Bereich von Anzeigeelementen, der Bildschirmtechnologie und der Beleuchtungstechnik. Die an diese Lichtquellen gestellten Anforderungen können zur Zeit von keiner der bestehenden Technologien völlig befriedigend gelöst werden.

Als Alternative zu herkömmlichen Anzeige- und Beleuchtungselementen, wie Glühlampen, Gasentladungslampen und nicht selbstleuchtenden Flüssigkristallanzeigeelementen, sind bereits seit einiger Zeit Elektrolumineszenz (EL)-materialien und -vorrichtungen, wie lichtemittierende Dioden (LED), in Gebrauch.

Neben anorganischen Elektrolumineszenzmaterialien und -vorrichtungen sind seit etwa 30 Jahren auch niedermolekulare, organische Elektrolumineszenzmaterialien und -vorrichtungen bekannt (siehe z. B. US-A-3,172,862). Bis vor kurzem waren aber solche Vorrichtungen in ihrer praktischen Anwendbarkeit stark eingeschränkt.

In der EP 423 283 und der EP 443 861 werden Elektrolumineszenzvorrichtungen beschrieben, die einen Film aus einem konjugierten Polymer als lichtemittierende Schicht (Halbleiterschicht) enthalten. Solche Vorrichtungen bieten zahlreiche Vorteile, wie die Möglichkeit, großflächige, flexible Displays einfach und kostengünstig herzustellen. Im Gegensatz zu Flüssigkristalldisplays sind Elektrolumineszenzdisplays selbstleuchtend und benötigen daher keine zusätzliche rückwärtige Beleuchtungsquelle.
Eine typische Vorrichtung nach der EP 423 283 besteht aus einer lichtemittierenden Schicht in Form eines dünnen, dichten Polymerfilms (Halbleiterschicht), der mindestens ein konjugiertes Polymer enthält. Eine erste Kontaktschicht steht in Kontakt mit einer ersten Oberfläche, eine zweite Kontaktschicht mit einer weiteren Oberfläche der Halbleiterschicht. Der Polymerfilm der Halbleiterschicht hat eine genügend geringe Konzentration von extrinsischen Ladungsträgem, so daß beim Anlegen eines elektrischen Feldes zwischen den beiden Kontaktschichten Ladungsträger in die Halbleiterschicht eingebracht werden, wobei die eine Kontaktschicht positiv gegenüber der anderen wird, und die Halbleiterschicht Strahlung aussendet. Die in solchen Vorrichtungen verwendeten Polymere werden als konjugiert bezeichnet. Unter konjugiertem Polymer versteht man ein Polymer, das ein delokalisiertes Elektronensystem entlang der Hauptkette besitzt. Das delokalisierte Elektronensystem verleiht dem Polymer Halbleitereigenschaften und gibt ihm die Möglichkeit, positive und/oder negative Ladungsträger mit hoher Mobilität zu transportieren.

In EP 423 283 und der EP 443 861 ist als polymeres Material für die lichtemittierende Schicht Poly-(p-phenylen-vinylen) beschrieben, welches zur Verbesserung der Eigenschaften mit Alkyl-, Alkoxy-, Halogen- oder Nitrosubstituenten am aromatischen Kern modifiziert werden kann. Derartige Polymere sind seither in einer großen Anzahl von Studien untersucht worden und insbesondere bisalkoxysubstituierte PPVs sind schon sehr weit in Richtung Anwendungsreife hin optimiert worden (vgl. z. B. J. Salbeck, Ber. Bunsenges. Phys. Chem. 1996, 100, 1667).

In der Patentanmeldung WO98/27136 sind arylsubstituierte Poly(p-arylenvinylene) beschrieben, die sich auch zur Erzeugung grüner Elektrolumineszenz eignen. Eine weitere Verbesserung der dort veröffentlichten Polymere geht aus WO99/24526 hervor. Hier wird auch ein Defekt in derartigen Polymeren offenbart: in der Hauptkette kommen je nach Polymer unterschiedliche Anteile von Dreifach- und Einfachbindungen (TBB-Defekt) vor. Der Anteil dieses Defekts steht offenbar in reziprokem Verhältnis zur erzielbaren Lebensdauer: ein hoher Defektanteil erniedrigt die operative Lebensdauer, ein niedriger Anteil erhöht diese deutlich. In der genannten Anmeldung WO99/24526 wird offenbart, daß die Defektrate durch das verwendete Substitutionsmuster beeinflußt werden kann, und daß diese Rate ausgehend von arylsubstituierten Monomeren (gemäß WO98/27136) durch das Einfügen von CN, F, Cl, einer Amino-, Alkyl- oder (Thio)alkoxygruppe deutlich erniedrigt werden kann.

Es wurde nun überraschend gefunden, daß sich Poly-(arylenvinylene), bei denen Poly-(arylphenylenvinylene)-Einheiten enthalten sind, deren Phenyleneinheit einen weiteren Aryl-Substituenten para oder meta zum ersten Arylrest trägt (vgl. Fig. I), diesen in der o. g. Anmeldung geschilderten Effekt unerwartet ausgeprägt aufweist. Dadurch kann die operative Lebensdauer in EL-Elementen noch weiter gesteigert werden. Dies ist natürlich von großer Anwendungsrelevanz und wirtschaftlicher Bedeutung. Die hohen EL-Effizienzen bleiben dabei erhalten.

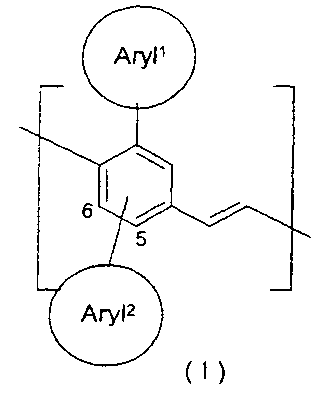

Aus US-A-5,558,904, insbesondere Spalte 5, 10, 13 und 23 sind Polymere analog Formel (I), bei denen die beiden Substituenten Aryl¹ und Aryl² entweder nicht, oder nur durch kurzkettige Substituenten (Fluor, Cyano, Methoxy, Phenyl) substituiert sind, offenbart. Homopolymere bzw. auch Copolymere mit einem Anteil derartiger Strukturen von größer ca. 25mol% sind aber - wie den nachfolgenden Vergleichsversuch entnehmbar - unlöslich.

Löslichkeit bzw. Unlöslichkeit im Sinne dieser Anmeldung sei definiert, wie dies auch in WO99/21936 (Seite 3, Zeilen 2 bis 7) angegeben wird: Lösliche Polymere bedeutet also, daß diese im Konzentrationsbereich von mindestens 0.5% in einem gebräuchlichen organischen Lösemittel (aromatische, sowie nichtaromatische Lösemittel, die Halogen enthalten können bzw. auch halogenfrei sein können, wie Toluol, Anisol, Chlorbenzol, Methylenchlorid, Chloroform, Xylol, Dioxan, THF, Cyclohexanon u. ä.) eine klare, ungelierte Lösung bei Raumtemperatur oder zumindest bei einer Temperatur unterhalb von 60°C, bevorzugt unterhalb von 50°C, besonders bevorzugt unterhalb von 40°C bilden. Diese Eigenschaft ist notwendig, um eine technische Verarbeitung zu dünnen Filmen gewährleisten zu können. Unlöslich im Sinne dieser Definition sind hingegen Polymere, die nur bei deutlich geringeren Konzentrationen eine klare Lösung ergeben, bzw. die bereits oberhalb von ca. 60°C gelieren.
Die erfindungsgemäßen Polymeren zeigen eine derartige Löslichkeit, demgegenüber besitzen die in US 5.558.904 offenbarten Polymere eine derartige Löslichkeit nicht, so daß diese nicht identisch sind. Die erfindungsgemäßen Polymere stellen eine deutliche Verbesserung gegenüber diesen Stand der Technik dar.

Aus US-A-5,817,430 ist ein Monomer mit einer Struktur bekannt, daß unter die in (I) angeführte allgemeine Formel fällt (Spalte 9). Das Patent beschäftigt sich mit der Löslichkeit von aus derartigen Monomeren hergestellten Polymeren. Die Löslichkeit wird jedoch im Gegensatz zu der vorliegenden Erfindung nicht durch geeignete Substitution bzw. Copolymerisation sondern durch Erniedrigung des Molekulargewichts erzielt wird. Diese Maßnahme ist dem Ziel einer langen operativen Lebensdauer in einer Elektrolumineszenzvorrichtung jedoch abträglich. Somit unterscheiden sich die offenbarten Polymere von der vorliegenden Erfindung.

Aus der japanischen Anmeldung JP 11 /97175 sind verschiedene Strukturen (vgl. Strukturen 1 bis 10, 13, 16 bis 19, 21 bis 26) vom Typ der Formel (I) bekannt. Allerdings trifft hier wiederum der zuvor gemachte Einwand: verwendet man diese Strukturen als Homopolymer oder auch nur mit einem Anteil von mehr als ca. 25%, so sind die resultierenden Polymere unlöslich im Sinne dieser Anmeldung.

Aus WO99/21936 sind durch die generische Formel (Seite 4, Seite 22; C2) und durch die Monomerbeispiele (Seite 15) Strukturen vom Typ der Formel (I) bekannt. Obwohl WO99/21936 lösliche Polymere offenbart (Seite 3), ist nicht bekannt, wie diese löslichen Polymere gerade mit den offenbarten Terphenylstrukturen erreicht werden sollen. Dies ist vor allem dann unklar, wenn diese Strukturen zu Anteilen von mehr als 25% enthalten sind, wie dies in WO99/21936 bevorzugt ist (Seite 2, Zeilen 6 bis 12 in Verbindung mit den Angaben in Tabelle 2, Seite 20).
Verwendet man das explizit genannte Monomer 4,4"-Bis-(3,7-dimethyloctyloxy)-2',5'-bis(chloromethyl)-p-terphenyl z. B. in einem Verhältnis von 30 Mol-% als Comonomer zusammen mit 2,5-Bis(chlormethyl)-3'-(3,7-dimethyloctyloxy)-biphenyl (vgl. Vergleichsbeispiele) erhält man Polymere, die im Sinne dieser Anmeldung unlöslich sind. Allgemein ist bei einem Anteil von mehr als 20% von 2,5-Bis-(4-substituierten phenyl)phenylen-vinylen-Strukturelementen mit Unlöslichkeit zu rechnen. Dies ist unabhängig vom gewählten Substituenten (z. B. Substituenten gemäß R¹, R' oder R" dieser Anmeldung) und modellhaft durch die hohe strukturelle Ordnung der dadurch erzielten Polyarylenvinylene zu erklären. Demzufolge unterscheiden sich die aus WO99/21936 bekannten Polymere vom vorliegenden Anmeldungsgegenstand.

Die im Stand der Technik beschriebenen Materialien zeigen zum einen keine besonderen Effekte für diese Strukturelemente und zum anderen auch nicht wünschenswerte Eigenschaften wie sie im Falle einer technischen Nutzung benötigt werden. Insbesondere wird im Stand der Technik versucht das Problem der Löslichkeit durch vielfältige Maßnahmen zu kontrollieren, ein Steuerung durch geeignete Substitution bzw. Copolymerisation derartig komplexer polymerer Materialien wird nicht vermittelt.

Gegenstand der Erfindung sind daher Poly(arylenvinylene), enthaltend mindestens 25 Mol-% einer oder mehrerer Wiederholeinheiten der Formel (I), 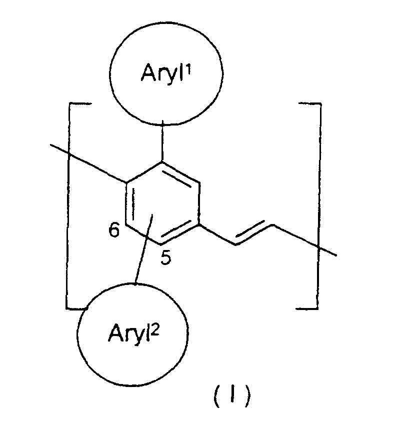 wobei die Symbole und Indizes folgende Bedeutungen haben:
- Aryl¹, Aryl²:: sind Aryl- bzw. Heteroarylgruppen mit 4 bis 14 C-Atomen, die jeweils wiederum mit 1 bis 5 Substituenten vom Typ R' substituiert sein können;
- R' :: ist, gleich oder verschieden bei jedem Auftreten, CN, F, Cl oder eine geradkettige, verzweigte oder cyclische Alkyl- oder Alkoxygruppe mit 1 bis 20 C-Atomen, wobei ein oder mehrere nicht benachbarte CH₂-Gruppen durch -O-, -S-, -CO-, -COO-, -O-CO-, -NR¹-, -(NR²R³)⁺-A⁻, oder -CONR⁴- ersetzt sein können und wobei ein oder mehrere H-Atome durch F ersetzt sein können, oder eine Aryl- oder Heteroarylgruppe mit 4 bis 14 C-Atome, die durch einen oder mehrere, nicht aromatische Reste R' substituiert sein kann;
- R¹,R²,R³,R⁴: sind gleich oder verschieden, H oder ein aliphatischer oder aromatischer Kohlenwasserstoffrest mit 1 bis 20 C-Atomen;
- A⁻ :: ein einfach geladenes Anion oder dessen Äquivalent;
dadurch gekennzeichnet, daß das Polymer löslich im Sinne des Anmeldungstextes ist;
mit der Maßgabe, daß die beiden Arylgruppen Aryl¹ und Aryl² derart mit R' Substituenten substituiert sind, daß die Gesamtzahl der in den verschiedenen oder gleichen Substituenten R' enthaltenen nicht-aromatischen C-Atome mindestens 4, bevorzugt mindestens 8, ganz besonders bevorzugt mindestens 12, ist,
und zugleich entweder der Gesamtanteil an Wiederholeinheiten (I) 50mol% nicht übersteigt, oder mindestens 5mol% einer ausgewählten, sperrigen, die Löslichkeit deutlich erhöhenden Wiederholeinheit vom Typ (II) oder (III) 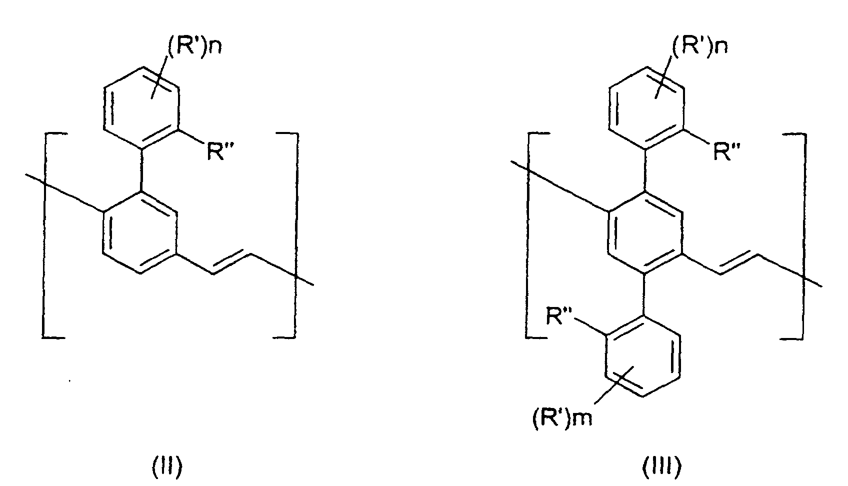 enthalten ist, wobei
- R" :: ist gleich oder verschieden, eine geradkettige, verzweigte oder cyclische C₁-C₆ Alkyl- oder Alkoxygruppe, wobei ein oder mehrere nicht benachbarte CH₂-Gruppen durch -O-, -S-, -CO-, -COO-, -O-CO-, -NR¹-, -(NR²R³)⁺-A⁻, oder -CONR⁴- ersetzt sein können und wobei ein oder mehrere H-Atome durch F ersetzt sein können, oder eine Aryl- oder Heteroarylgruppe mit 4 bis 12 C-Atome, die durch einen oder mehrere, nicht aromatische Reste R" substituiert sein kann;
- n, m :: gleich oder verschieden 0, 1, 2, 3, 4 bevorzugt 0, 1, 2;
die übrigen Reste die vorstehende Bedeutung haben,
mit der Maßgabe, das wenn die Wiederholeinheit der Formel (I) auch 2,5-Bis-(4-substituierte phenyl)-phenylen-vinylen-Strukturelemente enthält deren Summe 20 Mol% nicht übersteigt.

Bevorzugt ist R" gleich oder verschieden Phenyl oder C₁-C₆-Alkyl, besonders bevorzugt Methyl.

Die erfindungsgemäßen Polymere eignen sich in hervorragender Weise zur Verwendung als Elektrolumineszenzmaterialien. Sie zeigen beispielsweise den Vorteil, daß sie im Dauerbetrieb auch bei erhöhten Temperaturen (z. B. mehrstündiges Erhitzen auf 85°C) eine konstante Helligkeit aufweisen.

Somit ist es nicht notwendig, bei Dauerbetrieb die Spannung nachzuregulieren, um eine anfängliche Helligkeit zu erhalten. Dieser Vorteil macht sich insbesondere bei Batteriebetrieb bemerkbar, da hierbei die wirtschaftlich mögliche Höchstspannung stark eingeschränkt ist.

Ebenso weisen Vorrichtungen, die erfindungsgemäße Polymere enthalten, eine lange Lebensdauer sowie eine hohe EL Effizienz auf.

Die Polymere weisen im allgemeinen 10 bis 10000, vorzugsweise 20 bis 5000, besonders bevorzugt 100 bis 5000, ganz besonders bevorzugt 250 bis 2000 Wiederholeinheiten auf.

Erfindungsgemäße Polymere enthalten zu mindestens 25% Wiederholeinheiten der Formel (I), bevorzugt mindestens 30%.

Bevorzugt sind weiterhin auch Copolymere, bestehend aus Wiederholeinheiten der Formel (I) und Wiederholeinheiten, die unsubstiuierte und/oder substituierte Poly(arylenvinylen)-Strukturen aufweisen, vorzugsweise solche, die eine 2,5-Dialkoxy-1,4-phenylenvinylenstruktur und/oder eine 2-Aryl-1,4-arylenvinylenstruktur aufweisen.

Weiterhin bevorzugt sind Copolymere, die 1, 2 oder 3 verschiedene Wiederholeinheiten der Formel (I) aufweisen.
Copolymere im Sinne der Erfindung umfassen statistische, alternierende, reguläre sowie blockartige Strukturen.

Ebenso bevorzugt sind Polymere, enthaltend Wiederholeinheiten der Formel (I), bei denen die Symbole und Indizes folgende Bedeutungen haben:
- Aryl¹, Aryl²: ist gleich oder verschieden Phenyl, 1- bzw. 2-Naphthyl, 1-, 2- bzw. 9-Anthracenyl, 2-, 3- bzw. 4-Pyridinyl, 2-, 4- bzw. 5-Pyrimidinyl, 2-Pyrazinyl, 3- bzw. 4-Pyridazinyl, 2-, 3-, 4-, 5-, 6-, 7- bzw. 8-Chinolin, 2-bzw. 3-Thiophenyl, 2- bzw. 3-Pyrrolyl, 2- bzw. 3-Furanyl und 2-(1,3,4-Oxadiazol)yl;

Besonders bevorzugt sind Polymere, in denen in der Formel (I) die Arylsubstituenten Aryl¹, Aryl² folgende Bedeutung hat: Phenyl, 1-Naphthyl, 2-Naphthyl oder 9-Anthracenyl.

Des weiteren sind Polymere besonders bevorzugt, in denen in der Formel (I) die Arylsubstituenten Aryl¹, Aryl² folgendes Substitutionsmuster aufweisen:
2-, 3- bzw. 4-Alkyl(oxy)phenyl, 2,3-, 2,4-, 2,5-, 2,6-, 3,4- oder 3,5-Dialkyl(oxy)phenyl, 2,3,4,-, 2,3,5-, 2,3,6-, 2,4,5, 2,4,6- oder 3,4,5-Triaikyl(oxy)phenyl, 2-, 3-, 4-, 5-, 6-, 7-oder 8-Alkyl(oxy)-1-naphthyl, 1-, 3-, 4-, 5-, 6-, 7- oder 8-Alkyl(oxy)-2-naphthyl und 10-Alkyl(oxy)-9-anthracenyl.

Dabei ist es möglich, daß die beiden Arylsubstituenten Aryl¹ und Aryl² an einer Wiederholeinheit gemäß Formel (I) jeweils gleich oder verschieden voneinander sind. Verschiedenheit kann hier bereits durch ein unterschiedliches Substitutionsmuster gegeben sein. Dies kann zur Erhöhung der Löslichkeit eine bevorzugte Ausführungsform der Erfindung darstellen.

Die erfindungsgemäßen Polymere sind beispielsweise aus Edukten der Formel (IV), in welcher die Symbole und Indizes die unter Formel (I) erläuterte Bedeutung haben und Hal, Hal' für Cl, Br oder I stehen, durch Dehydrohalogenierungspolymerisation zu erhalten: dies geschieht in der Regel durch Umsetzung eines oder mehrerer Monomere in einem geeigneten Lösungsmittel mit einer geeigneten Base.

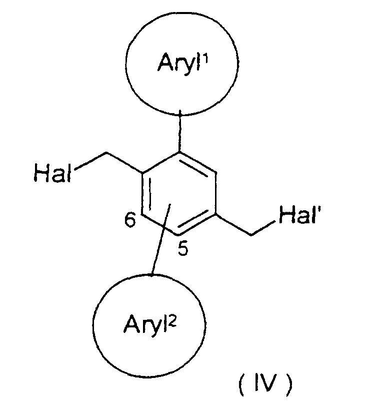

Eine Beschreibung der gängigen Polymerisationsvarianten ist in WO99/24526 und WO98/27136 gegeben. Auf den Text dieser Anmeldung wird hier ausdrücklich Bezug genommen und ist somit via Zitat Bestandteil der vorliegenden Anmeldung.

Symmetrische Terphenylderivate gemäß Formel (IV) können beispielsweise nach dem in Schema 1 skizzierten Weg gewonnen werden:

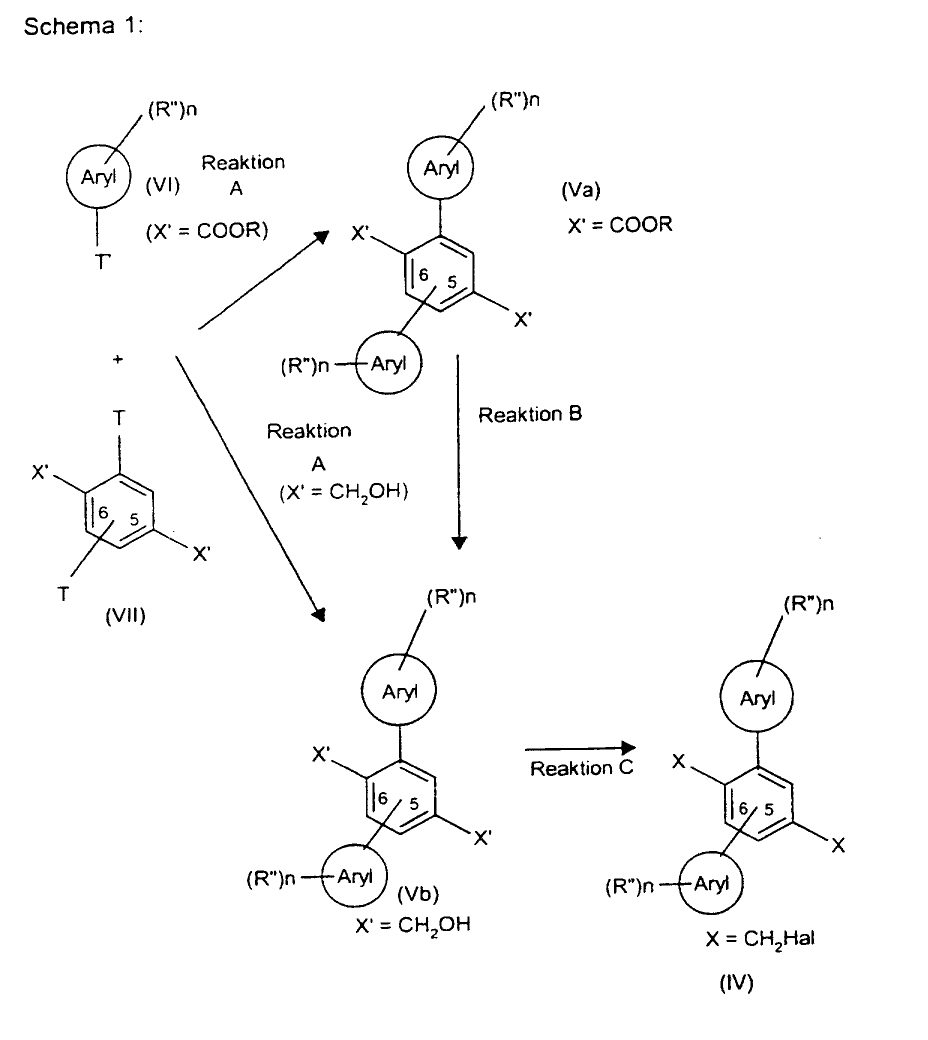

Unsymmetrische Terphenylderivate gemäß Formel (IV) können nach dem in Schema 2 skizzierten Weg gewonnen werden:

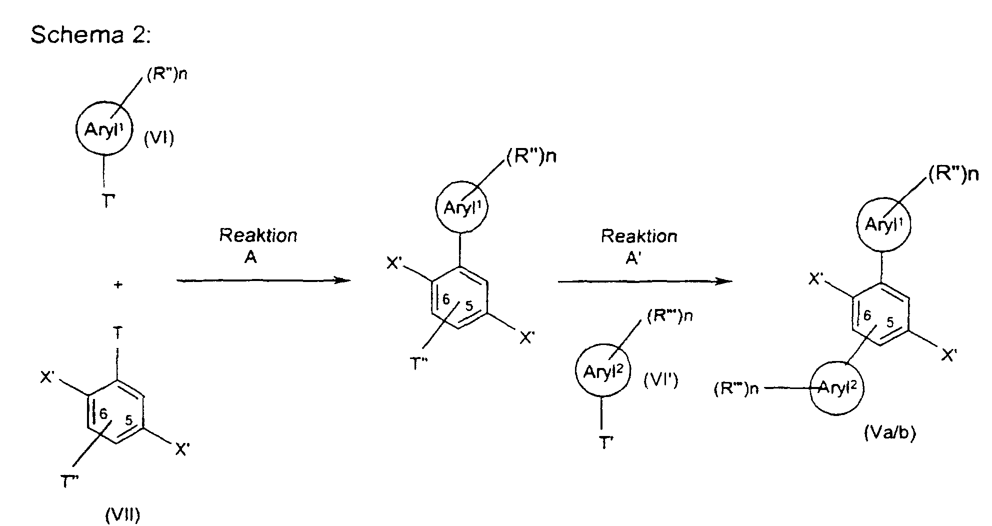

Die gemäß Schema 2 erhaltenen Zwischenstufen (Va/b) können analog Schema 1 dann gemäß Reaktionen B und C in die gewünschten Monomere umgewandelt werden.

Die Ausgangsverbindungen der Formeln (VI) und (VII) sind sehr gut zugänglich, da sie in einfacher Weise und großer Menge aus kommerziell erhältlichen Verbindungen herstellbar sind. Details hierzu sind aus der offengelegten Beschreibung von WO99/24526 zu entnehmen.

Die Durchführung der Reaktionen A (A'), B und C und deren bevorzugte Ausführungsformen sind ebenfalls in den o. g. Offenlegungsschriften (WO98/27136, WO99/24526) beschrieben und hiermit durch Zitat ausdrücklich als Bestandteil dieser Anmeldung zu verstehen.
Bei der Synthese zu unsymmetrischen Terphenylderivaten gemäß Schema 2 muß hierzu das Verfahren gemäß Reaktion A etwas modifiziert werden. Hierzu verwendet man eine Verbindung (VII) mit unterschiedlichen Funktionalitäten T (z. B. Br) und T' (z. B. Cl) und setzt diese hintereinander unter variierenden Bedingungen mit zwei verschiedenen Verbindungen vom Typ (VI) um. Dies kann beispielsweise durch zwei Suzukireaktionen geschehen: hier wird zunächst unter "normalen Bedingungen" (Reaktion A) (vgl. z. B. Beispiele C1 bis C10 in WO99/24526) nur die reaktivere Abgangsgruppe (Brom) ersetzt, und dann in einer zweiten Umsetzung unter geänderten Bedingungen (Optimierung für Chlor-Suzuki-Reaktionen vgl.: J. P.
Wolfe, S. L. Buchwald, *Angew. Chem*. 1999, *111*, 2570 und Zitate) die deutlich weniger reaktive Chlorgruppe ausgetauscht. Damit ist es einfach möglich Terphenyle mit unterschiedlichem Substitutionsmuster bzw. unterschiedlichen Arylringen zu synthetisieren.

Mit den hier erläuterten bzw. durch Zitat belegten Synthesemethoden lassen sich beispielsweise die nachfolgend aufgeführten Monomeren, welche zu erfindungsgemäßen Polymeren umgesetzt werden können, herstellen.

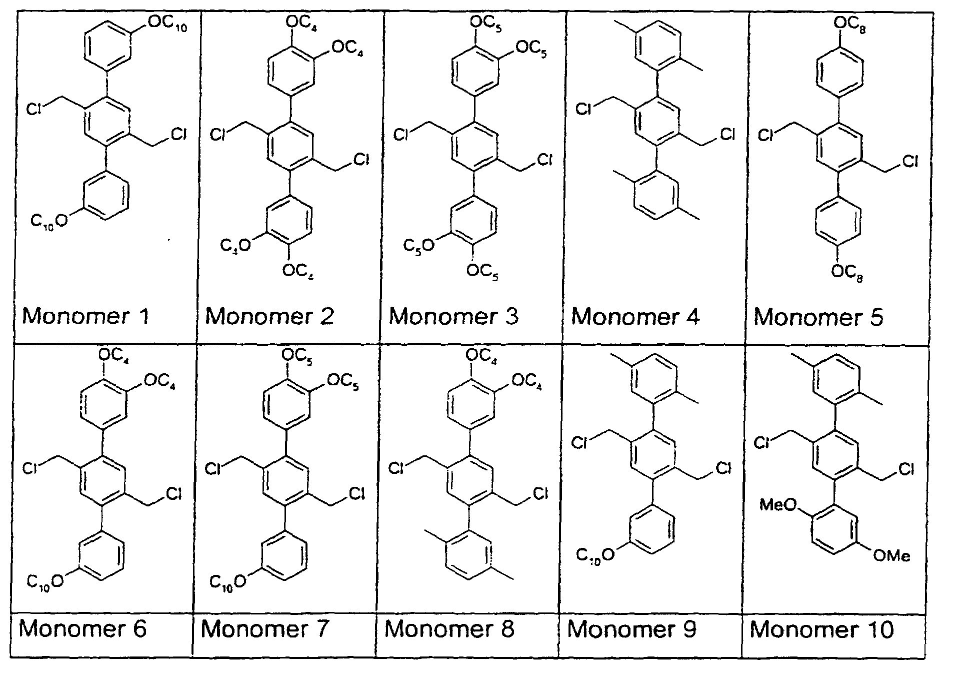

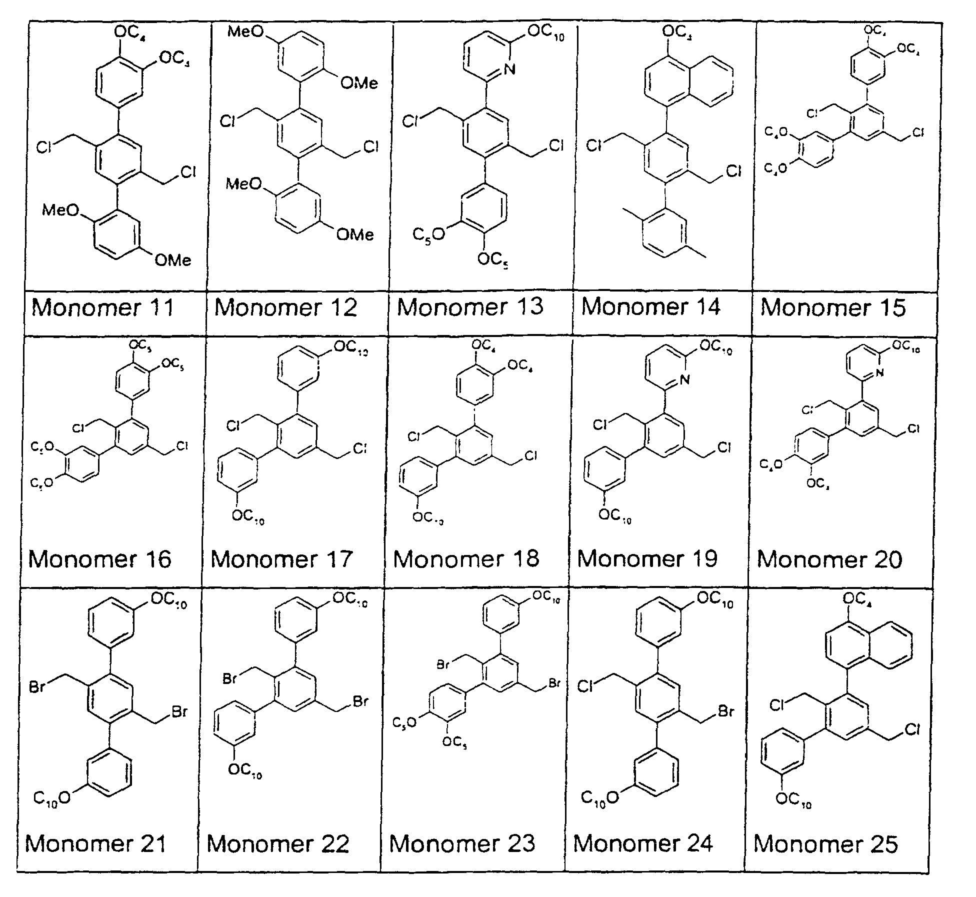

- Erläuterung:: C₄: 2-Methylpropyl; C₅: 2-Methylbutyl; C₈: 2-Ethylhexyl; C₁₀: 3,7-Dimethyloctyl.

Aus den derartig zugänglichen Monomeren nach Formel (II) lassen sich nun durch die oben angegebene Polymerisationsvariante - unter Zusatz weiterer Comonomere - Polymere, welche Wiederholeinheiten der Formel (I) enthalten, synthetisieren. Derartige Comonomere sind beispielsweise die im folgenden aufgeführten Verbindungen.

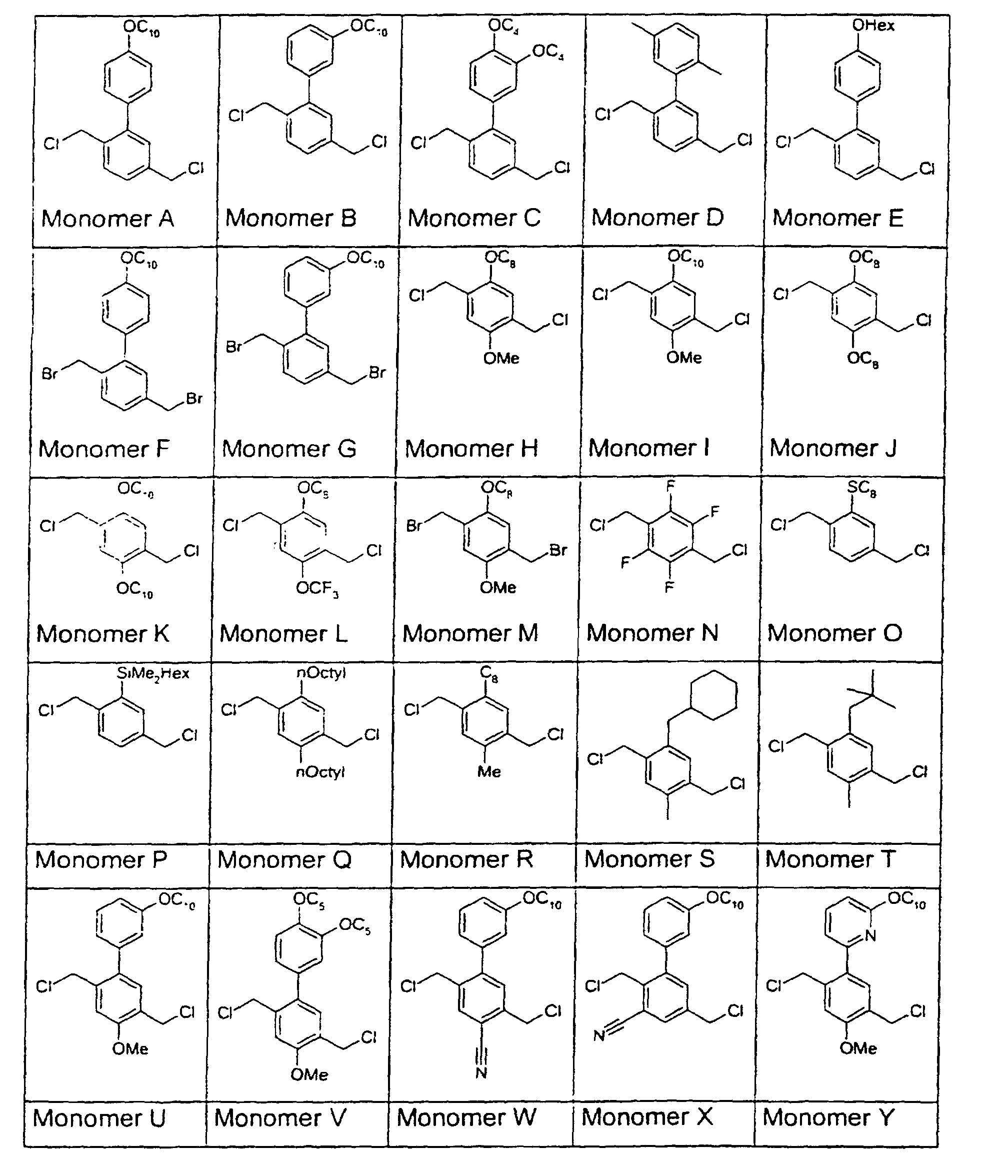

Erläuterung: C₄: 2-Methylpropyl; C₈: 2-Ethylhexyl; C₁₀: 3,7-Dimethyloctyl.

Die so erzeugten erfindungsgemäßen Polymere eignen sich ganz besonders als Elektroluminszenzmaterialien.

Als Elektrolumineszenzmaterialien im Sinne der Erfindung gelten Materialien, die als aktive Schicht in einer Elektrolumineszenzvorrichtung Verwendung finden können. Aktive Schicht bedeutet, daß die Schicht befähigt ist, bei Anlegen eines elektrischen Feldes Licht abzustrahlen (lichtemittierende Schicht) und/oder daß sie die Injektion und/oder den Transport der positiven und/oder negativen Ladungen verbessert (Ladungsinjektions- oder Ladungstransportschicht).

Gegenstand der Erfindung ist daher auch die Verwendung eines erfindungsgemäßen Polymers in einer Elektrolumineszenzvorrichtung, insbesondere als Elektrolumineszenzmaterial.

Um als Elektrolumineszenzmaterialien Verwendung zu finden, werden die Polymere, enthaltend Struktureinheiten der Formel (I), im allgemeinen nach bekannten, dem Fachmann geläufigen Methoden, wie Eintauchen (Dipping) oder Lackschleudern (Spincoating) oder verschiedenen Druckverfahren (z. B. Tintenstrahldrucken, off-set-Drucken), in Form eines Films auf ein Substrat aufgebracht.

Gegenstand der Erfindung ist somit ebenfalls eine Elektrolumineszenzvorrichtung mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht und/oder eine Transportschicht und/oder eine Ladungsinjektionsschicht sein.

Der allgemeine Aufbau solcher Elektrolumineszenzvorrichtungen ist beispielsweise in US 4,539,507 und US 5,151,629 beschrieben. Polymere enthaltende Elektrolumineszenzvorrichtungen sind beispielsweise in WO-A 90/13148 oder EP-A 0 443 861 beschrieben.

Sie enthalten üblicherweise eine elektrolumineszierende Schicht zwischen einer Kathode und einer Anode, wobei mindestens eine der Elektroden transparent ist. Zusätzlich können zwischen der elektrolumineszierenden Schicht und der Kathode eine oder mehrere Elektroneninjektions- und/oder Elektronentransportschichten eingebracht sein und/oder zwischen der elektrolumineszierenden Schicht und der Anode eine oder mehrere Lochinjektions- und/oder Lochtransportschichten eingebracht sein. Als Kathode können vorzugsweise Metalle oder metallische Legierungen, z. B. Ca, Mg, Al, In, Mg/Ag dienen. Als Anode können Metalle, z. B. Au, oder andere metallisch leitende Stoffe, wie Oxide, z. B. ITO (Indiumoxid/Zinnoxid) auf einem transparentem Substrat, z. B. aus Glas oder einem transparenten Polymer, dienen.

Im Betrieb wird die Kathode auf negatives Potential gegenüber der Anode gesetzt. Dabei werden Elektronen von der Kathode in die Elektroneninjektionsschicht-/Elektronentransportschicht bzw. direkt in die lichtemittierende Schicht injiziert. Gleichzeitig werden Löcher von der Anode in die Lochinjektionsschicht/ Lochtransportschicht bzw. direkt in die lichtemittierende Schicht injiziert.

Die injizierten Ladungsträger bewegen sich unter dem Einfluß der angelegten Spannung durch die aktiven Schichten aufeinander zu. Dies führt an der Grenzfläche zwischen Ladungstransportschicht und lichtemittierender Schicht bzw. innerhalb der lichtemittierenden Schicht zu Elektronen/Loch-Paaren, die unter Aussendung von Licht rekombinieren.
Die Farbe des emittierten Lichtes kann durch die als lichtemittierende Schicht verwendeten Materialien variiert werden.

Elektrolumineszenzvorrichtungen finden z. B. Anwendung als selbstleuchtende Anzeigeelemente, wie Kontrollampen, alphanumerische Displays, Hinweisschilder, und in optoelektronischen Kopplern.

Die Erfindung wird durch die nachfolgenden Beispiele näher erläutert, ohne sie dadurch einschränken zu wollen.

### Teil 1: Synthese der Monomere

### A. Synthese von Verbindungen der Formel (VII)

### Beispiel A1: Synthese von 2,5-Dibromterephthalsäurediethylester:

### a) Synthese von 2,5-Dibrom-p-xylol

Zu einer vorgelegten Mischung aus p-Xylol (637 g, 6 mol) und Fe-Pulver (10 g) in Dichlormethan (1300 ml) wurde unter Rühren tropfenweise Brom (1918 g, 12 mol) zugesetzt. Der Beginn der Reaktion war durch Gasentwicklung sichtbar. Danach tropfte man das restliche Brom bei Raumtemperatur unter Wasserbadkühlung innerhalb von 5 h zu. Die Reaktionsmischung wurde über Nacht weitergerührt. Anschließend wurde mit gesättigter wäßriger Na2SO3-Lösung und HCl ausgerührt. Die entfärbte Lösung wurde noch einmal mit verdünnter wäßriger NaOH und zweimal mit H2O ausgeschüttelt, anschließend wurde das Lösemittel im Vakuum entfernt. Das erhaltene Rohprodukt wurde durch Umkristallisation aus Hexan (ca. 800 ml) weiter gereinigt.
Das Produkt erhielt man als farbloses kristallines Pulver: 1281 g (81%). Schmelzpunkt: 71.8°C
1H NMR (CDCl3): [ppm] = 7.38 (s, 2 H, H-Aryl), 2.32 (s, 6 H, CH3).

### b) Synthese von 2,5-Dibromterephthalsäure

In einem 1-I-Autoklav (HC-22) mit Scheibenrührer, Rückflußkühler, Gaseinleitung und Gasauslaß wurde eine Lösung von Kobaltacetattetrahydrat (1.25 g, 5 mmol), Manganacetat-tetrahydrat (1.23 g), HBr (0.81 g), Natriumacetat (1.37 g) und 2,5-Dibrom-p-xylol (132 g, 0.5 mol) in 500 g Eisessig vorgelegt.
Die Reaktionslösung wurde unter Stickstoffatmosphäre (17 bar) unter Rühren auf 150°C erhitzt. Bei dieser Temperatur wurde Luft (17 bar) durch die Lösung geleitet (180-200 l/h), worauf die exotherme Reaktion sofort ansprang. Die Reaktionstemperatur blieb durch Außenkühlung bei 150°C. Nach ca. 45 Minuten war die exotherme Reaktion beendet. Zur Ermöglichung einer Nachreaktion wurde bei 150°C für 30 min. ein Luft/Stickstoff-Gemisch (10% 02) durchgeleitet. Danach wurde die Luftzufuhr abgebrochen und Stickstoff eingeleitet.
Der Reaktorinhalt wurde unter Stickstoffatmosphäre auf 100°C abgekühlt, als Lösung in einen Kolben abgelassen und unter Rühren auf 20°C abgekühlt, wobei das Produkt auskristallisierte. Der farblose Kristallbrei wurde abgesaugt und viermal mit jeweils 50 g Eisessig gewaschen.
Nach Trocknung erhielt man 118.2 g 2,5-Dibromterephthalsäure (73%). Schmelzpunkt: 316-318°C
1H NMR (DMSO): [ppm] = 13.5 (br, 2 H, COOH), 8.01 (s, 2 H, H-Aryl).

### c) Synthese von 2,5-Dibromterephthalsäurediethylester

2,5-Dibromterephthalsäure (290 g, 895 mmol) wurde mit 150 ml EtOH unter Schutzgas vorgelegt und dann bei RT unter Rühren mit H2SO4 (8.8 g) versetzt. Anschließend refluxierte man bei 78°C Innentemperatur am Rückfluß und destillierte EtOH ab, bis die Innentemperatur über 100 °C lag. Es wurde zunächst erneut Ethanol zugeführt, dieses dann wieder abdestilliert. Der Vorgang wurde solange wiederholt, bis laut DC nur noch der Diester vorhanden war. Schließlich wurde alles Ethanol abgezogen, und auf das noch heiße Reaktionsprodukt ca. 250 ml Heptan gegeben. Man ließ unter Rühren auskristallisieren. Die Kristalle wurden abgesaugt, nochmals mit einem Ultra-Turrax in 500 ml Heptan aufgeschlämmt und erneut abgesaugt.
Man erhielt 307 g (90%) farblose Kristalle.
Schmelzpunkt: 124°C
1H NMR (CDCl3): [ppm] = 8.02 (s, 2 H, H-Aryl), 4.42 (q, 4 H, OCH2, J = 7.5 Hz), 1.42 (t, 6 H, CH3, J = 7.5 Hz).

### Beispiel A2: Synthese von 2-Brom-5-chlorterephthalsäurediethylester: vergleiche Beschreibung in WO99/24526

### B. Synthese von Verbindungen der Formel (Vl)

Beispiel B1: Synthese von 3-(3,7-Dimethyloctyloxy)benzolboronsäure:
Beispiel B2: Synthese von 4-(3,7-Dimethyloctyloxy)benzolboronsäure:
Beispiel B3: Synthese von 3,4-Bis(2-methylpropyloxy)benzolboronsäure
Beispiel B4: Synthese von 2,5-Dimethoxybenzolboronsäure:
Beispiel B5: Synthese von 2,5-Dimethylbenzolboronsäure:
vergleiche jeweils die Beschreibung in WO99/24526

### Beispiel B6: Synthese von 3,4-Bis(2-methylbutyloxy)benzolboronsäure

### a) Synthese von 1,2-Bis(-2-methylbutyloxy)benzol:

Brenzkatechin (165.17 g, 1.5 mol) wurde in 600 ml Ethanol vorgelegt, mit 149 g KOH (2.25 mol, gelöst in 210 ml Wasser) versetzt und zum Rückfluß erhitzt. Anschließend wurden 194 g (1.6 mol) 2-Methylbutyltosylat (hergestellt aus 2-Methylbutanol und Tosylchlorid) zugetropft. Nach weiteren 3 Stunden refluxieren wurden nochmals dieselben Mengen KOH und 2-Methylbutyltosylat zugegeben und über Nacht weiterrefluxiert. Anschließend wurde das Lösemittel abrotiert, der feste Reaktionsrückstand mit Wasser und Toluol aufgenommen und schließlich die Phasen getrennt. Die wässrige Phase wurde nochmals mit Toluol, die vereinigten organischen Phasen mit Wasser ausgewaschen und über Na2SO4 getrocknet. Das nach Abziehen des Lösungsmittels erhaltene niederviskose Rohprodukt wurde im Vakuum fraktioniert destilliert.
Man erhielt das Produkt als farbloses Öl (Siedepunkt: 109°C bei 0.18 mbar): 247 g (66%).
1H NMR (CDCl3): [ppm] = 6.88 (ps-s, 4 H, H-Aryl), 3.80 (m, 4 H, O-CH2), 1.90 (m, 2 H, C-H), 1.59 (m, 2 H, C-H), 1.28 (m, 2 H, C-H), 1.04 (d, 6 H, CH3, J = 8 Hz), 0.94 (t, 6 H, CH3, J = 8 Hz).

### b) Synthese von 3,4-Bis(2-methylbutyloxy)brombenzol:

1,2-Bis(-2-methylbutyloxy)benzol (338 g, 1.35 mol) wurde in 2.5 I Acetonitril vorgelegt, auf 0°C gekühlt und mit 264 g (1.48 mol) N-Bromsuccinimid versetzt. Es wurde auf RT erwärmt und noch für 90 Minuten nachgerührt. Nach Abziehen des Acetonitrils wurde mit Toluol und Wasser versetzt, die Phasen getrennt. Nach Rückschütteln der wässrigen Phase mit Toluol und Trocknung der organischen Phase über Na2SO4 wurde das Toluol abgezogen.
Das Rohprodukt wurde durch doppelte fraktionierte Destillation im Vakuum gereinigt. Man erhielt das Produkt als farbloses Öl (145°C, 1.3 mbar): 275 g (62%).
1H NMR (CDCl3): [ppm] = 6.98 (m, 2 H, H-2, H-6), 6.73 (m, 1 H, H-5), 3.77, (m, 4 H, O-CH2), 1.90 (m, 2 H, C-H), 1.57 (m, 2 H, C-H), 1.28 (m, 2 H, C-H), 1.04 (m, 6 H, CH3), 0.94 (m, 6 H, CH3).

### c) Synthese von 3,4-Bis(2-methylbutyloxy)benzolboronsäure:

Durchführung analog zu Beispiel B3 in WO99/24526.
Ausbeute: 76%
1H NMR (CDCl3): [ppm] = 7.82 (dd, 1 H, H-6, J1 = 8 Hz, J2 = 1.8 Hz), 7.69 (d, 1 H, H-2, J = 1.8 Hz), 7.01 (d, 1 H, H-5, J = 8 Hz), 3.93 (m, 4 H, O-CH2), 1.95 (m, 2 H, C-H), 1.62 (m, 2 H, C-H), 1.30 (m, 2 H, C-H), 1.05 (m, 6 H, CH3), 0.97 (m, 6 H, CH3). Enthält variable Anteile von Anhydriden.
Beispiel B7: Benzolboronsäure
Beispiel B8: 3-Methoxybenzolboronsäure
Diese beiden Verbindungen wurden von ALDRICH gekauft.

### C.1. Kupplungsreaktionen gemäß Reaktion A

### Beispiel C1: Synthese von 2,5-Bis[3,4-bis(2-methylpropyloxy)phenyl]-terephthalsäurediethylester

Durchführung analog Beispiel C1 in WO99/24526. Edukte: 1 Äquivalent A1 und 2.2 Äquivalente B3.
Ausbeute: 96% eines wachsigen Feststoffs.
1H NMR (CDCl3): [ppm] = 7.72 (s, 2 H, H-3, H-6), 6.88 (m, 6 H, H-Aryl), 4.13 (q, 4 H, CO2CH2, J = 7.5 Hz), 3.80, 3.75 (2 x d, 2 x 4 H, O-CH2, J = 7.6 Hz), 2.13 (m, 4 H, C-H), 1.04 (m, 24 + 6 H, Me).

### Beispiel C2: Synthese von 2,5-Bis[3-(3,7-dimethyloctyloxy)phenyl]-terephthalsäurediethylester

Durchführung analog Beispiel C1. Edukte: 1 Äquivalent A1 und 2.2 Äquivalente B1. Ausbeute: 100% eines gelblichen, zähen Öls.

### Beispiel C3: Synthese von 2,5-Bis[3,4-bis(2-methylbutyloxy)phenyl]-terephthalsäurediethylester

Durchführung analog Beispiel C1. Edukte: 1 Äquivalent A1 und 2.2 Äquivalente B6. Ausbeute: 95% eines zähen Öls, das über Nacht erstarrt.
Schmelzpunkt: 70°C
1H NMR (CDCl3): [ppm] = 7.73 (s, 2 H, H-3'/6'), 6.88 (m, 6 H, H-Aryl), 4.13 (q, 4 H, CO2CH2, J = 7.5 Hz), 3.83 (m, 8 H, O-CH2), 1.93 (m, 4 H, C-H), 1.60 (m, 4 H, C-H), 1.31 (m, 4 H, C-H), 1.05 (m, 12 + 6 H, CH3, CO2CH2CH3), 0.96 (m, 12 H, CH3):

### Beispiel C4: Synthese von 2.5-Diphenyl-terephthalsäurediethylester

Durchführung analog Beispiel C1. Edukte: 1 Äquivalent A1 und 2.2 Äquivalente B7. Ausbeute: 98% eines kömigen Feststoffs.

### Beispiel C5: Synthese von 2,5-Bis[3-methoxyphenyl]-terephthalsäurediethylester

Durchführung analog Beispiel C1. Edukte: 1 Äquivalent A1 und 2.2 Äquivalente B8. Ausbeute: 99% eines wachsigen Feststoffs.

### Beispiel C6: Synthese von Synthese von 2,5-Bis[4-(3,7-dimethyloctyloxy)phenyl]-terephthalsäurediethylester

Durchführung analog Beispiel C1. Edukte: 1 Äquivalent A1 und 2.2 Äquivalente B2. Ausbeute: 92% eines langsam erstarrenden Öls.

### Beispiel C7: Synthese von 2,5-Bis(2,5-dimethylphenyl)-terephthalsäurediethylester

Durchführung analog Beispiel C1. Edukte: 1 Äquivalent A1 und 2.2 Äquivalente B 5. Ausbeute: 97% eines braunen wachsigen Feststoffs.
Schmelzpunkt: 158°C
1H-NMR (CDCl3): [ppm] = 7.79 (s, 2 H, H-3', H-6'), 7.11 (m, 4 H, H-3, H-4, H-3", H-4''), 6.98 (m, 2 H, H-6, H-6''), 4.07 (q, 4 H, CO2CH2, J = 7.1 Hz), 2.34 (s, 6 H, CH3), 2.09 (s, 6 H, CH3), 0.99 (t, 6 H, CO2CH2CH3, J = 7.1 Hz).

### Beispiel C8: Synthese von 5-Chlor-2-(2',5'-Dimethylphenyl)terephthalsäurediethylester

Durchführung analog Beispiel C1. Edukte: 1 Äquivalent A2 und 1.1 Äquivalente B 5. Ausbeute: 98% eines farblosen, niederviskosen Öls.
1H-NMR (CDCl3): [ppm] = 7.99, 7.67 (s, 2 H, H-3, H-6), 7.10 (m, 2 H, H-3', H-4'), 6.88 (br. s, 1 H, H-6'), 4.40 (q, 2 H, CO2CH2, J = 7.2 Hz), 4.07 (q, 2 H, CO2CH2, J = 7.2 Hz) 2.32 (s, 3 H, CH3), 2.02 (s, 3 H, CH3), 1.39 (t, 3 H, CO2CH2CH3, J = 7.2 Hz), 0.99 (t, 3 H, CO2CH2CH3, J = 7.2 Hz).

### C.2. Kupplungsreaktionen gemäß Reaktion A'

### Beispiel C9: Synthese von 2-(2,5-Dimethylphenyl)-5-(3,4-(2-methylbutyloxy)phenyl)-terephthalsäurediethylester

Eine Mischung von 5-Chlor-2-(2',5'-Dimethylphenyl)terephthalsäurediethylester (137 g, 0.38 mol), 3,4-Bis(2-methylbutyloxy)benzolboronsäure (144 g 0.49 mol), wasserfreiem Cäsiumcarbonat (212 g 0.65 mol) und 500 ml wasserfreiem Dioxan wurde unter Rühren 30 min. im Argonstrom entgast. Anschließend wurde Tri-tertbutylphosphin (2,4 g, 12 mmol) und dann Palladium-(II)-acetat (1,3 g 6 mmol) zugefügt. Die Suspension wurde unter Argon-Atmosphäre 16 h bei 70°C gerührt. Zur 70°C warmen Reaktionslösung wurde eine Lösung von N,N-Diethyldithiocarbaminsäure Natruimsalz Trihydrat (5 g, 22 mmol) in 100 ml Wasser zugefügt. Nach Abkühlen der Reaktionsmischung wurde die organische Phase abgetrennt. Die wäßrige Phase wurde zwei mal mit 100 ml Essigsäureethylester extrahiert. Anschießend wurden die vereinigten organischen Phasen über Celitte filtriert. Das Filtrat wurde mit 200 ml Wasser und mit 200 ml gesättigter, wäßriger Natriumchlorid-Lösung gewaschen und über Natriumsulfat getrocknet. Nach Abfiltrieren des Trockenmittels und Entfernen der flüchtigen organischen Bestandteile im Vakuum (10-1 mbar, 80°C, 6 h) erhielt man 206 g (95 %) eines hochviskosen Öls.
1H-NMR (CDCl3): [ppm] = 7.92, 7.59 (s, 2 H, H-3', H-6'), 7.10, 6.90 (m, 6 H, H-3, H-4, H-6, H-2'', H-5", H-6''), 4.14 (q, 2 H, CO2CH2, J = 7.1 Hz), 4.06 (q, 2 H, CO2CH2, J = 7.1 Hz), 3.84 (m, 4 H, OCH2), 2.33, 2.08 (s, 6 H, CH3), 1.93 (m, 2 H, CH), 1.61 (m, 2 H, CH2), 1.31 (m, 2 H, CH2), 1.06 (m, 6 + 6 H, CH3, CO2CH2CH3), 0.96 (m, 6 H, CH3).

### D. Reduktionen gemäß Reaktion B

### Beispiel D1: Synthese von 3,4,3",4"-Tetrakis-(2-methylpropyloxy)-p-terphenyl-2',5'-dimethanol

Durchführung analog Beispiel D1 in WO99/24526. Edukt: C1
Ausbeute nach Ausrühren: 75%.
Schmelzpunkt: 161 °C
1H NMR (CDCl3): [ppm] = 7.44 (s, 2 H, H-3', H-6'), 6.94 (m, 6 H, H-Aryl), 4.67 (s, 4 H, CH2-O), 3.79, 3.76 (2 x d, 2 x 4 H, O-CH2, J = 7.6 Hz), 2.13 (m, 4 H, C-H), 1.06, 1.03 (2 x d, 2 x 12 H, CH3, J = 7.4 Hz).

### Beispiel D2: Synthese von 3,3"-Bis-(3,7-dimethyloctyloxy)-p-terphenyl-2',5'-dimethanol

Durchführung analog Beispiel D1. Edukt: C2
Ausbeute nach Ausrühren: 91 %.
1H NMR (CDCl3): [ppm] = 7.48 (s, 2 H, H-3'/6'), 7.33 (t; 2 H; J = 8 Hz; H-5/5"), 6.96 (m; 6 H; H-2/2", H-4/4", H-6/6"), 4.68 (s, 4 H, CH2O), 4.03 (m, 4 H, O-CH2), 1.85 (m, 2 H, H-3), 1.60 (m, 6 H, H-2, H-7), 1.25 (m, 12 H, H-4, H-5, H-6), 0.95 (d, 6 H, Me, J = 7.5 Hz), 0.86 (d, 12 H, Me, J = 7.5 Hz).

### Beispiel D3: Synthese von 3,4,3",4"-Tetrakis-(2-methylbutyloxy)-p-terphenyl-2',5'-dimethanol

Durchführung analog Beispiel D1. Edukt: C3
Ausbeute nach Ausrühren: 71 %.
1 H NMR (CDCl3): [ppm] = 7.45 (s, 2 H, H-3'/6'), 6.94 (m, 6 H, H-Aryl), 4.66 (s, 4 H, CH2-O), 3.84 (m, 8 H, O-CH2), 1.94 (m, 4 H, C-H), 1.60 (m, 4 H, C-H), 1.30 (m, 4 H, C-H), 1.05 (m, 12 H, CH3), 0.97 (m, 12 H, CH3).

### Beispiel D4: Synthese von p-Terphenyl-2',5'-dimethanol

Durchführung analog Beispiel D1. Edukt: C4
Ausbeute nach Ausrühren: 88%.
1H NMR (CDCl3): [ppm] = 7.44 (s, 2 H, H-3'/6'), 7.35, 7.15 (2 x m, 4 + 6 H, H-Aryl), 4.63 (s, 4 H, CH2-O).

### Beispiel D5: Synthese von 3,3"-Bis-methoxy-p-terphenyl-2',5'-dimethanol

Durchführung analog Beispiel D1. Edukt: C5
Ausbeute nach Ausrühren: 95%.
1H NMR (CDCl3): [ppm] = 7.48 (s, 2 H, H-3'/6'), 7.32 (t; 2 H; J = 8 Hz; H-5/5"), 6.96 (m; 6 H; H-2/2", H-4/4", H-6/6"), 4.67 (s, 4 H, CH2O), 3.78 (s, 6 H, O-CH3).

### Beispiel D6: Synthese von 4,4"-Bis-(3,7-dimethyloctyloxy)-p-terphenyl-2',5'-dimethanol

Durchführung analog Beispiel D1. Edukt: C6
Ausbeute nach Ausrühren: 87%.
1H NMR (CDCl3): [ppm] = 7.46 (s, 2 H, H-3'/6'), 7.29, 6.96 (AA'BB'; 8 H; H-Aryl), 4.67 (s, 4 H, CH2O), 4.02 (m, 4 H, O-CH2), 1.86 (m, 2 H, H-3), 1.61 (m, 6 H, H-2, H-7), 1.25 (m, 12 H, H-4, H-5, H-6), 0.95 (d, 6 H, Me, J = 7.5 Hz), 0.87 (d, 12 H, Me, J = 7.5 Hz).

Beispiel D7: Synthese von 2,5, 2", 5''-Tetrakis-methyl-p-terphenyl-2',5'-dimethanol Durchführung analog Beispiel D1, mit unten beschriebener Aufarbeitung. Edukt: C7 Zur Aufarbeitung gab man nach beendeter Reduktion vorsichtig 8 ml Wasser zu. Anschließend wurde 8 ml wäßrige NaOH-Lösung (15%ig) und schließlich 24 ml Wasser zugegeben. Nach jeder Zugabe wurde für ca. 15 min. nachgerührt ("1:1:3-Methode"). Der angefallene Feststoff wurde abgesaugt, mit 250 ml THF gewaschen und getrocknet. Nach Trocknen wurde der Feststoff in 500 ml DMSO bei 150° digeriert und dann noch heiß filtriert. Der Filterrückstand wurde verworfen. Aus dem Filtrat fiel beim Abkühlen ein kristalliner, farbloser Feststoff aus, der abgesaugt und mit 100 ml kaltem DMSO nachgewaschen wurde. Abschließend wurde der Feststoff mit 200 ml Aceton ausgerührt und nach Absaugen getrocknet.
Ausbeute: 41 g (80 %).
1H-NMR (DMSO-d6): [ppm] = 7.20 (m, 4 H, H-3, H-4, H-3", H-4''), 7.09 (m, 2 H, H-6, H-6''), 6.95 (s, 2 H, H-3', H-6'), 4.97 (m, 2 H, OH), 4.18 (m, 4 H, CH2O), 2.30 (s, 6 H, CH3), 2.08, 2.00 (s, 6 H, CH3).

### Beispiel D8: Synthese von 2,5-Dimethyl-3",4"-(2-methylbutyloxy)-p-terphenyl-2',5'-dimethanol

Durchführung analog Beispiel D1. Edukt C9
Ausbeute nach Ausrühren: 72 %.
1H-NMR (CDCl3): [ppm] = 7.43, 7.27 (s, 2 H, H-3', H-6'), 7.16, 7.08 (m, 2 H, H-6, H-2"), 6.07, 6.92 (m, 4 H, H-3, H-4, H-5'', H-6"), 4.63 (d, 2 H, CH2O, J = 5,9 Hz), 4.43 (d, 2 H, CH2O, J = 6.0 Hz), 3.87, 3.82 (m, 4 H, OCH2), 2.32, 2.06 (s, 6 H, CH3), 1.92 (m, 2 H, CH), 1.74 (t, 1 H, OH, J = 5.9 Hz), 1.64 (t, 1 H, OH, J = 6.0 Hz), 1.60 (m, 2 H, CH2), 1.31 (m, 2 H, CH2), 1.05 (m, 6 H, CH3), 0.96 (m, 6 H, CH3).

### E. Halogenierungen gemäß Reaktion C

### Beispiel E1: Synthese von 3,4,3",4"-Tetrakis-(2-methylpropyloxy)-2',5'-dichloromethyl-p-terphenyl

265 g (458 mmol) D1 wurden in 500 ml Dioxan gelöst und bei RT einer Lösung von 218 g (1.8 mol) Thionylchlorid in 130 ml Dioxan zugetropft. Der Ansatz wurde über Nacht bei RT gerührt. Es wurde mit NaHC03 Lösung neutralisiert; das dabei bereits ausgefallene (saubere) Produkt wird abgesaugt. Weiteres Produkt wird durch Phasentrennen, Ausschütteln mit Wasser, Abziehen des organischen Lösemittels und schließlich Ausrühren mit Hexan erhalten.
Gesamtausbeute nach Ausrühren: 206 g (73%).
Schmelzpunkt: 126°C
1H NMR (CDCl3): [ppm] = 7.46 (s, 2 H, H-3'/6'), 7.03, 6.95 (2 x m, 2 + 4 H, H-Aryl), 4.56 (s, 4 H, CH2Cl), 3.82, 3.80 (2 x d, 2 x 4 H, O-CH2, J = 7.7 Hz), 2.15 (m, 4 H, C-H), 1.07, 1.04 (2 x d, 2 x 12 H, CH3, J = 7.5 Hz).

### Beispiel E2: Synthese von 3,3"-Bis-(3,7-dimethyloctyloxy)-2',5'-dichloromethyl-p-terphenyl

Durchführung analog Beispiel E1. Edukt: D2
Ausbeute nach Ausrühren: 84%.
Schmelzpunkt: 66° C
1H NMR (CDCl3): [ppm] = 7.48 (s, 2 H, H-3'/6'), 7.36 (pseudo-t; 2 H; J = 8 Hz; H-5/5"), 7.02, 6.95 (2 x m; 4 + 2 H; H-2/2", H-4/4", H-6/6"), 4.55 (s, 4 H, CH2Cl), 4.05 (m, 4 H, O-CH2), 1.86 (m, 2 H, H-3), 1.60 (m, 6 H, H-2, H-7), 1.25 (m, 12 H, H-4, H-5, H-6), 0.95 (d, 6 H, Me, J = 7.5 Hz), 0.87 (d, 12 H, Me, J = 7.5 Hz).

### Beispiel E3: Synthese von 3,4,3",4"-Tetrakis-(2-methylbutyloxy)-2',5'-dichloromethyl-p-terphenyl

Durchführung analog Beispiel E1. Edukt: D3
Das Produkt fällt sauber als langsam kristallisierendes Öl an.
Ausbeute: 87%.
Schmelzpunkt: 56°C
1H NMR (CDCl3): [ppm] = 7.45 (s, 2 H, H-3'/6'), 7.03, 6.95 (2 x m, 2 + 4 H, H-Aryl), 4.56 (s, 4 H, CH2Cl), 3.86 (m, 8 H, O-CH2), 1.93 (m, 4 H, C-H), 1.61 (m, 4 H, C-H), 1.32 (m, 4 H, C-H), 1.06 (m, 12 H, CH3), 0.97 (m, 12 H, CH3).

### Beispiel E4: Synthese von 2',5'-Dichloromethyl-p-terphenyl

Durchführung analog Beispiel E1. Edukt: D4
Das Produkt fällt sauber als farblose Kristalle an.
Ausbeute: 89%.
Schmelzpunkt: 214°C
1H NMR (CDCl3): [ppm] = 7.47 (s, 2 H, H-3'/6'), 7.32, 7.13 (2 x m, 4 + 6 H, H-Aryl), 4.54 (s, 4 H, CH2Cl).

### Beispiel E5: Synthese von 3,3"-Bismethoxy-2',5'-dichloromethyl-p-terphenyl

Durchführung analog Beispiel E1. Edukt: D5
Ausbeute nach Ausrühren: 82%.
Schmelzpunkt: 145°C
1H NMR (CDCl3): [ppm] = 7.47 (s, 2 H, H-3'/6'), 7.34 (pseudo-t; 2 H; J = 8 Hz; H-5/5"), 7.01, 6.95 (2 x m; 4 + 2 H; H-2/2", H-4/4", H-6/6"), 4.55 (s, 4 H, CH2Cl), 3.75 (s, 6 H, O-CH3).

### Beispiel E6: Synthese von 4,4"-Bis-(3,7-dimethyloctyloxy)-2',5'-dichloromethyl-p-terphenyl

Durchführung analog Beispiel E1. Edukt: D6
Ausbeute nach Ausrühren: 84%.
Schmelzpunkt: 118°C
1H NMR (CDCl3): [ppm] = 7.48 (s, 2 H, H-3'/6'), 7.30, 6.97 (AA'BB'; 8 H; H-Aryl), 4.55 (s, 4 H, CH2Cl), 4.04 (m, 4 H, O-CH2), 1.86 (m, 2 H, H-3), 1.60 (m, 6 H, H-2, H-7), 1.26 (m, 12 H, H-4, H-5, H-6), 0.95 (d, 6 H, Me, J = 7.5 Hz), 0.86 (d, 12 H, Me, J = 7.5 Hz).

### Beispiel E7: Synthese von 2,5, 2", 5''-Tetrakis-methyl-2',5'-dichloromethyl-p-terphenyl

Durchführung analog Beispiel E1, wobei eine Suspension von D7 in 1000 ml Dioxan - Anstelle der im Beispiel E1 beschriebenen Lösung - verwendet wurde. Edukt D7. Ausbeute nach Ausrühren: 84 %.
Schmelzpunkt: 114°C
1H-NMR (CDCl3): [ppm] = 7.34 (s, 2 H, H-3', H-6'), 7.19, 7.12, 7.06 (m, 6 H, H-3, H-4, H-6, H-3'', H-4", H-6"), 4.36 (m, 4 H, CH2Cl), 2.36 (s, 6 H, CH3), 2.10, 2.08 (s, 6 H, CH3).

### Beispiel E8: Synthese von 2,5-Dimethyl-3",4"-(2-methylbutyloxy)-2',5'-dichloromethyl-p-terphenyl

Durchführung analog Beispiel E 1. Edukt D8

Das Produkt fällt nach Entfernen der flüchtigen organischen Bestandteile im Vakuum (10-1 mbar, 60°C, 6 h) sauber als hochviskoses farbloses Öl an.
Ausbeute: 99 %.
1H-NMR (CDCl3): [ppm] = 7.48, 7.32 (s, 2 H, H-3', H-6'), 7.19, 7.12 (m, 2 H, H-6, H-2" ). 7.04, 6.96 (m, 4 H, H-3, H-4, H-5'', H-6''), 4.55 (s, 2 H, CH2Cl), 4.43, 4.32 (d, 2 H. CH2Cl, J = 11.5 Hz), 3.92, 3.84 (m, 4 H, OCH2), 2.35, 2.10 (s, 6 H, CH3), 1.95 (m, 2 H, CH), 1.61 (m, 2 H, CH2), 1.32 (m, 2 H, CH2), 1.06 (m, 6 H, CH3), 0.97 (m, 6 H, CH3).

### Z. Synthese von Comonomeren

Die Synthese verschiedener Comonomere (wie diejenigen, die in dieser Anmeldung beispielhaft als Comonomere A bis Y bezeichnet sind), ist ausführlich und im Detail in den beiden offengelegten Anmeldungen WO98/27136 und WO99/24526 beschrieben.

### Teil 2: Synthese und Charakterisierung der Polymere:

Die Zusammensetzung der Copolymere P1 sowie P2 wurde durch oxidativen Abbau und nachfolgende qualitative und quantitative Analyse der so zurückerhaltenen Monomereinheiten belegt. Es wurde gefunden, daß der Anteil der Monomereinheiten im Copolymer gleich dem in der Synthese eingesetzten Verhältnis der Monomere war.

### P: Synthese von erfindungsgemäßen Polymeren:

### Beispiel P1:

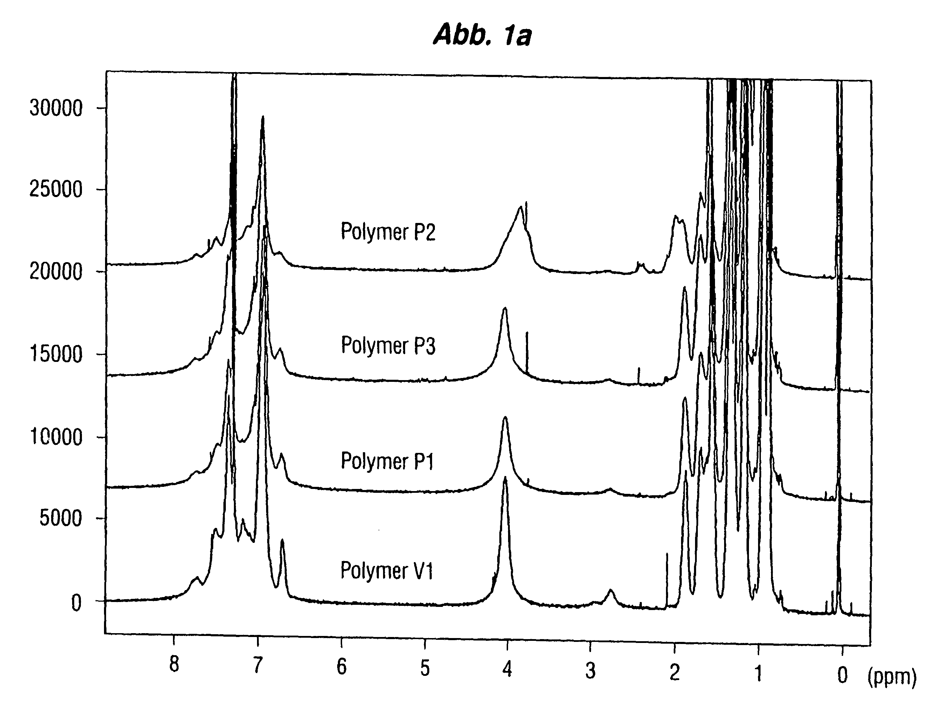

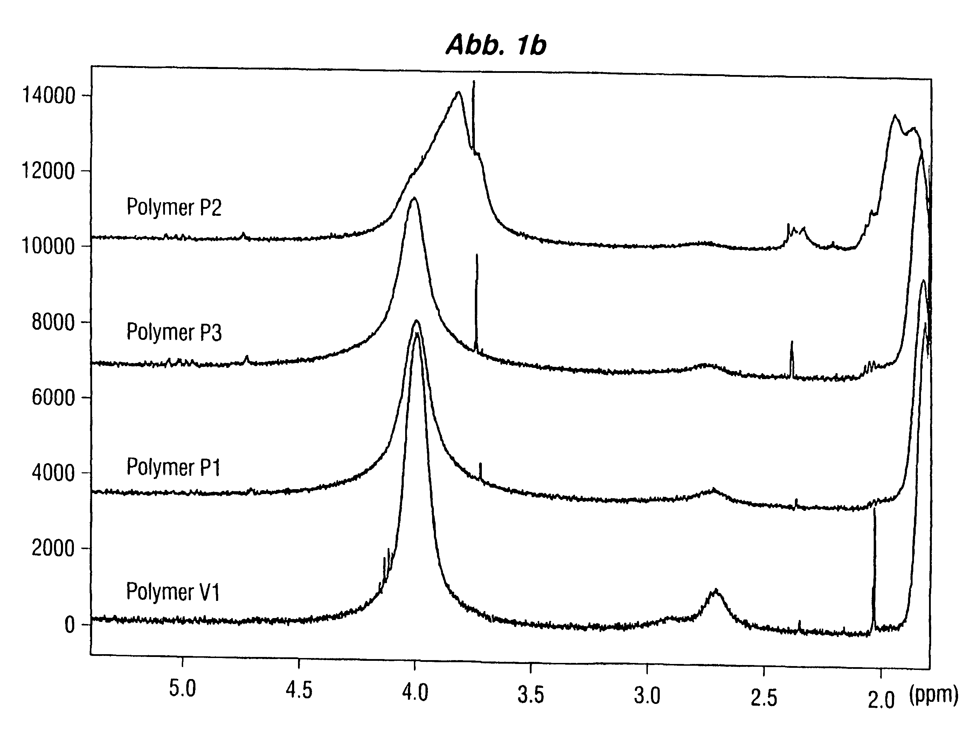

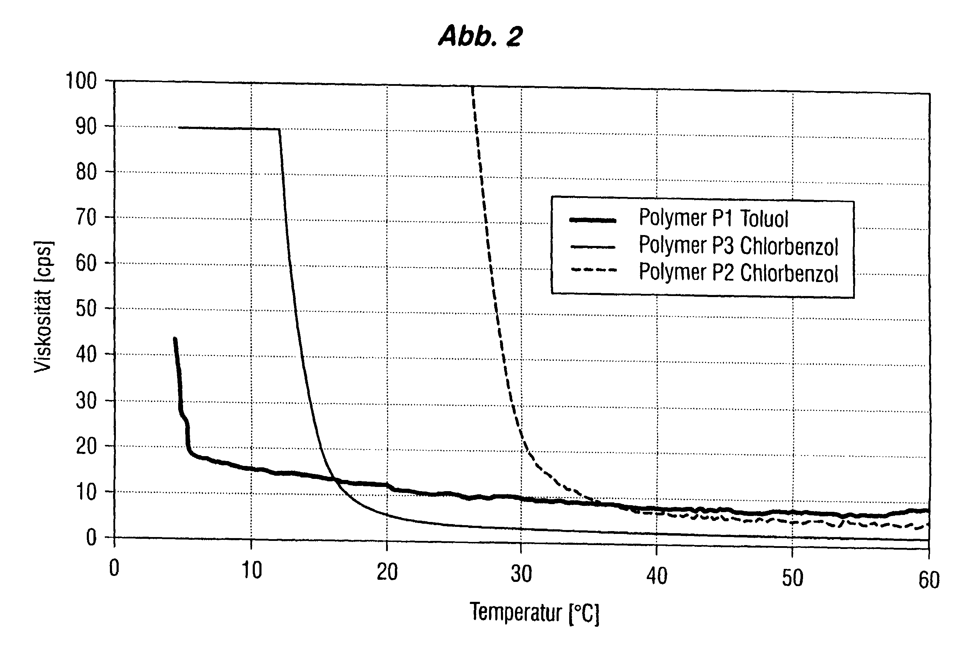

Copolymer aus 30% E2 und 70% 2,5-Bis(chlormethyl)-3'-(3,7-dimethyloctyloxy)-biphenyl (Polymer P1):
Herstellung von Poly(2,5-bis[3'-(3,7-dimethyloctyloxy)phenyl]-pphenylenvinylen)co(2-(3'-(3,7-dimethyloctyloxy)phenyl)-p-phenylenvinylen).
Die Herstellung des Polymers P1 erfolgte analog zu Beispiel P1 in WO99/24526. Dazu wurden 7.28 g (11.38 mmol) 3,3"-Bis-(3,7-dimethyloctyloxy)-2',5'-dichloromethyl-p-terphenyl (Beispiel E2) und 10.82 g (26.55 mmol) 2,5-Bis(chlormethyl)-3'-(3,7-dimethyloctyloxy)-biphenyl (siehe WO99/24526, Beispiel Z3 c) mit insgesamt 189.8 ml 1 M KOtBu in insgesamt 2.3 L 1,4-Dioxan umgesetzt. Nach analoger Reinigung erhielt man 8.1 g (53%) des Polymers P1 als gelbe Fasern.
1H NMR (CDCl3): [ppm] = 8.1-6.6 (br. m, 9.9 H; Olefin-H, Harom); 4.0 (br. s, 2.6 H; O-CH2); 2.7 (br. s; Bisbenzyl); 1.9-0.8 (br. m; 24.7 H, Alkyl-H).
Durch die Integration des Signals bei 2.7 ppm errechnete sich ein Gehalt an TBB Gruppen von 7.6%. Das 1H NMR Spektrum von Polymer P1 ist in Abbildung 1 wiedergegeben.
GPC: THF + 0.25% Oxals.; Säulensatz SDV500, SDV1000, SDV10000 (Fa. PSS), 35°C, UV Detektion 254 nm, Polystyrol-Standard: Mw = 1.2×106 g/mol, Mn = 2.0×105 g/mol.
Eine Lösung des Polymers P1 vergelt in einer Lösung 5 mg/ml in Toluol bei einer Temperatur <6°C (siehe Abbildung 2).

### Beispiel P2:

Copolymer aus 50% E3, 40% 2,5-Bis(chlormethyl)-3'-(3,7-dimethyloctyloxy)-biphenyl und 10% 2,5-Bis(chlormethyl)-2'5'-dimethylbiphenyl (Polymer P2):
Herstellung von Poly(2,5-bis(3',4'-bis[2-methylbutyloxyphenyl])-p-phenylenvinylen)co(2-(3'-(3,7-dimethyloctyloxy)phenyl)-p-phenylenvinylen)co(2-(2',5'-dimethylphenyl)-p-phenylenvinylen).

Die Herstellung des Polymers P2 erfolgte analog zu Beispiel P1 in WO99/24526. Dazu wurden 12.75 g (18.97 mmol) 3,4,3",4"-Tetrakis-(2-methylbutyloxy)-2',5'-dichloromethyl-p-terphenyl (Beispiel E3), 6.18 g (15.17 mmol) 2,5-Bis(chlormethyl)-3'-(3,7-dimethyloctyloxy)-biphenyl sowie 1.08 g (3.79 mmol) 2,5-Bis(chlormethyl)-2',5'-dimethylbiphenyl (siehe WO98/27136, Beispiel E4) mit insgesamt 191 ml 1 M KOtBu in insgesamt 2.3 L 1,4-Dioxan umgesetzt. Nach analoger Reinigung erhielt man 9.44 g (55%) des Polymers P2 als gelbes fasriges Polymer.
1H NMR (CDCl3): [ppm] = 7.8-6.7 (br. m, 9.4 H; Olefin-H, Harom); 4.1-3.5 (br. m, 4.8 H; O-CH2); 2.8-2.7 (br. s; Bisbenzyl); 2.3 (m, 0.3 H, 1 x CH3); 2.0-0.8 (br. m; 16.9 H, Alkyl-H und 1 x CH3).
Durch die Integration des Signals bei 2.8 - 2.7 ppm errechnete sich ein Gehalt an TBB Gruppen von 3.9%. Das 1H NMR Spektrum von Polymer P2 ist in Abbildung 1 wiedergegeben.
GPC: THF + 0.25% Oxals.; Säulensatz SDV500, SDV1000, SDV10000 (Fa. PSS), 35°C, UV Detektion 254 nm, Polystyrol-Standard: Mw = 1.8×106 g/mol, Mn = 2.0×105 g/mol.
Eine Lösung des Polymers P2 vergelt in einer Lösung 5 mg/ml in Chlorbenzol bei einer Temperatur <32°C (siehe Abbildung 2).

### Beispiel P3:

Copolymer aus 40% E2 und 60% 2,5-Bis(chlormethyl)-3'-(3,7-dimethyloctyloxy)-biphenyl (Polymer P3):
Herstellung von Poly(2,5-bis[3-(3,7-dimethyloctyloxy)phenyl]-p-phenylenvinylen)co(2-(3'-(3,7-dimethyloctyloxy)phenyl)-p-phenylenvinylen).

Die Herstellung des Polymers P3 erfolgte analog zu Beispiel P1 in WO99/24526. Dazu wurden 9.71 g (15.18 mmol) 3,3"-Bis-(3,7-dimethyloctyloxy)-2',5'-dichloromethyl-p-terphenyl (Beispiel E2) und 9.28 g (22.77 mmol) 2,5-Bis(chlormethyl)-3'-(3,7-dimethyloctyloxy)-biphenyl mit insgesamt 189.9 ml 1M KOtBu in insgesamt 2.3 L 1,4-Dioxan umgesetzt. Nach analoger Aufarbeitung und Reinigung erhielt man 9.32 g (57%) des Polymers P3 als gelbe Fasern.
1H NMR (CDCl3): [ppm] = 8.1-6.6 (br. m, 10.2 H; Olefin-H, Harom); 4.0 (br. s, 2.8 H; O-CH2); 2.7 (br. s; Bisbenzyl); 1.9-0.8 (br. m; 26.6 H, Alkyl-H).
Durch die Integration des Signals bei 2.7 ppm errechnete sich ein Gehalt an TBB Gruppen von 6.7%. Das 1H NMR Spektrum von Polymer P3 ist in Abbildung 1 wiedergegeben.
GPC: THF + 0.25% Oxals.; Säulensatz SDV500, SDV1000, SDV10000 (Fa. PSS), 35°C, UV Detektion 254 nm, Polystyrol-Standard: Mw = 1.7×106 g/mol, Mn = 3.0×105 g/mol.

Eine Lösung des Polymers P3 vergelt in einer Lösung 5 mg/ml in Chlorbenzol bei einer Temperatur <16°C (Siehe Abbildung 2).

### Beispiel P4: (HB972)

Copolymer aus 20% E3, 20% E4 und 60% 2,5-Bis(chlormethyl)-3',4'-bis(2-methylpropyloxy)-biphenyl (Polymer P4): HB 1200 Herstellung von Poly[(2-(3',4'-bis(2-methylpropyloxy)phenyl)-p-phenylenvinylen)co(2,5-bis(3,4-bis(3-methylbutyloxy)phenyl)-p-phenylenvinylen)co(2,5-bis(2,5-dimethylphenyl)-p-phenylenvinylen)]

Die Herstellung des Polymers P4 erfolgte analog zu Beispiel dem Beispiel P1. Dazu wurden 7.65 g (11.38 mmol) 3,4,3",4"-Tetrakis-(2-methylbutyloxy)-2',5'-dichloromethyl-p-terphenyl (Beispiel E3), 4.36 g (11.38 mmol) 2,5,2",5"-Tetrakis-methyl-2',5'-dichloromethyl-p-terphenyl (Beispiel E4), 13.50 g (34.15 mmol) 2,5-Bis(chlormethyl)-3',4'-bis(2-methylpropyloxy)-biphenyl mit insgesamt 286ml 1M KOtBu in insgesamt 3.5 L 1,4-Dioxan umgesetzt. Nach analoger Reinigung erhielt man 12.14 g (57%) des Polymers P4 als gelbes fasriges Polymer.
1 H NMR (CDCl3): [ppm] = 7.8-6.6 (br. m, 8.8 H; Olefin-H, Harom); 3.7 (br. s, 4.0 H; O-CH2); 2.8-2.7 (br. s; Bisbenzyl); 2.2-0.8 (br. m; 18.0 H, Alkyl-H und 2 x CH3). Durch die Integration des Signals bei 2.8-2.7 ppm errechnete sich ein Gehalt an TBB Gruppen von 4%.
GPC: THF + 0.25% Oxalsäure; Säulensatz SDV500, SDV1000, SDV10000 (Fa. PSS), 35°C, UV Detektion 254 nm, Polystyrol-Standard: Mw = 1.8×106 g/mol, Mn = 3.6×105 g/mol.

### Beispiel P5:

Copolymer aus 40% E8 und 60% 2,5-Bis(chlormethyl)-3',4'-bis(2-methylpropyloxy)-biphenyl (Polymer P5): HB 1205
Herstellung von Poly[(2-(3',4'-bis(2-methylpropyloxy)phenyl)-p-phenylenvinylen)co(2-(3,4-bis(3-methylbutyloxy)phenyl)5-(2,5-bismethyl)phenyl-p-phenylenvinylen)]

Die Herstellung des Polymers P5 erfolgte analog zu Beispiel dem Beispiel P1. Dazu wurden 12.01 g (22.77 mmol) 2,5-Dimethyl-3",4"-(2methylbutyloxy)-2',5'-dichloromethyl-p-terphenyl (Beispiel E8) und 13.50 g (34.15 mmol) 2,5-Bis(chlormethyl)-3',4'-bis(2-methylpropyloxy)-biphenyl mit insgesamt 285 ml 1M KOtBu in insgesamt 3.4 L 1,4-Dioxan umgesetzt. Nach analoger Aufarbeitung und Reinigung erhielt man 10.25 g (48%) des Polymers P5 als gelbes Pulver.
1H NMR (CDCl3): [ppm] = 7.9-6.7 (br. m, 8.8 H; Olefin-H, Harom); 3.8 (br. s, 4.0 H; O-CH2); 2.8-2.7 (br. s; Bisbenzyl); 2.25-0.7 (br. m; 18.0 H, Alkyl-H und 2 x CH3). Durch die Integration des Signals bei 2.8-2.7 ppm errechnete sich ein Gehalt an TBB Gruppen von 5%.
GPC: THF + 0.25% Oxalsäure; Säulensatz SDV500, SDV1000, SDV10000 (Fa. PSS), 35°C, UV Detektion 254 nm, Polystyrol-Standard: Mw = 1.2×106 g/mol, Mn = 2.5×105 g/mol. In 0.5 %iger Lösung in Toluol zeigt das Polymer keine Vergelung bis zu mindestens 0°C.

### Beispiel P6:

Copolymer aus 25% E3, 25% E4, 25% 2,5-Bis(chlormethyl)-3',4'-bis(2-methylpropyloxy)-biphenyl und 25% 2,5-Bis(chlormethyl)-3',4'-bis(2-methylbutyloxy)-biphenyl (Polymer P6): HB 1221
Herstellung von Poly[(2-(3',4'-bis(2-methylpropyloxy)phenyl)-p-phenylenvinylen)co(2-(3',4'-bis(2-methylbutyloxy)phenyl)-p-phenylenvinylen)co(2,5-bis(3,4-bis(3-methylbutyloxy)phenyl)-p-phenylenvinylen)co(2,5-bis(2,5-dimethylphenyl)-p-phenylenvinylen)]

Die Herstellung des Polymers P6 erfolgte analog zu Beispiel den Beispielen P1P5. Es wurden 9.56 g (14.23 mmol) 3,4,3",4"-Tetrakis-(2-methylbutyloxy)-2',5'-dichloromethyl-p-terphenyl (Beispiel E3), 5.46 g (14.23 mmol) 2,5,2",5"-Tetrakis-methyl-2',5'-dichloromethyl-p-terphenyl (Beispiel E4), 5.63 g (14.23 mmol) 2,5-Bis(chlormethyl)-3',4'-bis(2-methylpropyloxy)-biphenyl sowie 6.03 g (14.23 mmol) 2,5-Bis(chlormethyl)-3',4'-bis(2-methylbutyloxy)-biphenyl mit insgesamt 284.6 ml 1M KOtBu in insgesamt 3.45 L 1,4-Dioxan umgesetzt. Nach analoger Reinigung erhielt man 9.83 g (44%) des Polymers P6 als gelbes fasriges Polymer.
1H NMR (CDCl3): [ppm] = 7.8-6.7 (br. m, 9.0 H; Olefin-H, Harom); 4.1-3.6 (br. m, 4.0 H; O-CH2); 2.8-2.7 (br. s; Bisbenzyl); 2.3-0.8 (br. m; 20.0 H, Alkyl-H und CH3). Durch die Integration des Signals bei 2.8-2.7 ppm errechnete sich ein Gehalt an TBB Gruppen von 4.2%.
GPC: THF + 0.25% Oxalsäure; Säulensatz SDV500, SDV1000, SDV10000 (Fa. PSS), 35°C, UV Detektion 254 nm, Polystyrol-Standard: Mw = 2.2×106 g/mol, Mn = 3.8×105 g/mol. In Toluol (5mg/ml) zeigt das Polymer keine Vergelung bis <15°C.

### Beispiel P7:

Copolymer aus 25% E3, 25% E4 und 50% 2,5-Bis(chlormethyl)-3',4'-bis(2-methylbutyloxy)-biphenyl (Polymer P7): HB 1227
Herstellung von Poly[(2-(3',4'-bis(2-methylbutyloxy)phenyl)-p-phenylenvinylen)co(2,5-bis(3,4-bis(3-methylbutyloxy)phenyl)-p-phenylenvinylen)co(2,5-bis(2,5-dimethylphenyl)-p-phenylenvinylen)]

Die Herstellung des Polymers P7 erfolgte analog zu Beispiel den Beispiel P6. Es wurden 9.56 g (14.23 mmol) 3,4,3",4"-Tetrakis-(2-methylbutyloxy)-2',5'-dichloromethyl-p-terphenyl (Beispiel E3), 5.46 g (14.23 mmol) 2,5,2",5"-Tetrakis-methyl-2',5'-dichloromethyl-p-terphenyl (Beispiel E4) und 12.05 g (28.50 mmol) 2,5-Bis(chlormethyl)-3',4'-bis(2-methylbutyloxy)-biphenyl mit insgesamt 284.6 ml 1M KOtBu in insgesamt 3.45 L 1,4-Dioxan umgesetzt. Nach analoger Reinigung erhielt man 10.6 g (46%) des Polymers P7 als gelbes fasriges Polymer.
1H NMR (CDCl3): [ppm] = 7.8-6.7 (br. m, 9.0 H; Olefin-H, Harom); 4.1-3.6 (br. m, 4.0 H; O-CH2); 2.8-2.7 (br. s; Bisbenzyl); 2.3-0.8 (br. m; 21.0 H, Alkyl-H und CH3). Durch die Integration des Signals bei 2.8-2.7 ppm errechnete sich ein Gehalt an TBB Gruppen von 4.9%.
GPC: THF + 0.25% Oxalsäure; Säulensatz SDV500, SDV1000, SDV10000 (Fa. PSS), 35°C, UV Detektion 254 nm, Polystyrol-Standard: Mw = 2.2×106 g/mol, Mn = 3.6×105 g/mol. In Toluol (5mg/ml) zeigt das Polymer keine Vergelung bis <18°C.

### Beispiel P8:

Copolymer aus 25% E3, 25% E4, 24.5% 2,5-Bis(chlormethyl)-3',4'-bis(2-methylpropyloxy)-biphenyl, 25% 2,5-Bis(chlormethyl)-3',4'-bis(2-methylbutyloxy)-biphenyl, 0.5% 2,5-Bis(chlormethyl)-1-methoxy-4-(3,7-dimethyloctyloxy)benzol
(Polymer P8): HB 1245
Herstellung von Poly[(2-(3',4'-bis(2-methylpropyloxy)phenyl)-p-phenylenvinylen)co(2-(3',4'-bis(2-methylbutyloxy)phenyl)-p-phenylenvinylen)co(2,5-bis(3,4-bis(3-methylbutyloxy)phenyl)-p-phenylenvinylen)co(2,5-bis(2,5-dimethylphenyl)-p-phenylenvinylen)co(2-(3,7-dimethyloctyloxy)-5-methoxy)p-phenylenvinylen]

Die Herstellung des Polymers P8 erfolgte analog zu Beispiel den Beispielen P1P5. Es wurden 9.56 g (14.23 mmol) 3,4,3",4"-Tetrakis-(2-methylbutyloxy)-2',5'-dichloromethyl-p-terphenyl (Beispiel E3), 5.46 g (14.23 mmol) 2,5,2",5"-Tetrakis-methyl-2',5'-dichloromethyl-p-terphenyl (Beispiel E4), 5.51 g (13.94 mmol) 2,5-Bis(chlormethyl)-3',4'-bis(2-methylpropyloxy)-biphenyl, 6.03 g (14.23 mmol) 2,5-Bis(chlormethyl)-3',4'-bis(2-methylbutyloxy)-biphenyl sowie 100 mg (0.28 mmol) 2,5-Bis(chlormethyl)-1-methoxy-4-(3,7-dimethyloctyloxy)benzol mit insgesamt 284.6 ml 1M KOtBu in insgesamt 3.45 L 1,4-Dioxan umgesetzt. Nach analoger Reinigung erhielt man 11.02g (49%) des Polymers P7 als gelb-orangene Fasern.
1H NMR (CDCl3): [ppm] = 7.8-6.5 (br. m, 8.98 H; Olefin-H, Harom); 4.0-3.6 (br. m, 4.01 H; O-CH2); 2.8-2.7 (br. s; Bisbenzyl); 2.3-0.8 (br. m; 20.03 H, Alkyl-H).
Durch die Integration des Signals bei 2.8-2.7 ppm errechnete sich ein Gehalt an TBB Gruppen von 3.2%.
GPC: THF + 0.25% Oxalsäure; Säulensatz SDV500, SDV1000, SDV10000 (Fa. PSS), 35°C, UV Detektion 254 nm, Polystyrol-Standard: Mw = 1.3×106 g/mol, Mn = 2.2×105 g/mol. In Toluol (5mg/ml) zeigt das Polymer keine Vergelung bis <12°C.

### V. Synthese von nicht erfindungsgemäßen Vergleichsbeispielen:

### Beispiel V1:

Herstellung von Poly[2-(3'-(3,7-dimethyloctyloxy)phenyl)-p-phenylenvinylen]
Zur Herstellung des Polymers V1 siehe Vergleichsbeispiel V6 in WO99/24526.
1 H NMR (400 MHz, CDCl3): (ppm) = 7.9-7.0 (br. m; 9 H; HArom, HOlefin); 4.0 (br. s, 2 H); 2.7 (br. s; Bisbenzyl); 1.9-1.1 (br. m, 10H); 0.85, 0.83 (2 s, 9H).
Durch die Integration des Signals bei 2.7 ppm errechnete sich ein Gehalt an TBB Gruppen von 12%. Das 1H-NMR Spektrum von Polymer V1 ist in Abbildung 1 wiedergegeben.
GPC: THF + 0.25% Oxalsäure; Säulensatz SDV500, SDV1000, SDV10000 (Fa. PSS), 35°C, UV Detektion 254 nm, Polystyrol-Standard: Mw = 1.2×106 g/mol, Mn = 1.1×105 g/mol.

### Beispiel V2

Copolymer aus 50% 2',5'-Bis(chlormethyl)-p-terphenyl (E4) und 50% 2,5-Bis(chlormethyl)-3'-(3,7-dimethyloctyloxy)-biphenyl (Polymer V2):
Herstellung von Poly(2,5-diphenyl-p-phenylenvinylen)co(2-(3'-(3,7-dimethyloctyloxy)phenyl)-p-phenylenvinylen).

Die Polymerisationsreaktion erfolgte analog zu Beispiel P1 in WO99/24526. Dazu wurden 5.40 g (16.5 mmol) 2',5'-bis(chloromethyl)-p-terphenyl (Beispiel E4) und 6.72 g (16.5 mmol) 2,5-Bis(chlormethyl)-3'-(3,7-dimethyloctyloxy)-biphenyl mit insgesamt 165 ml 1 M KOtBu in insgesamt 2 L 1,4-Dioxan umgesetzt. Während der Reaktion fiel das Polymer spontan als feiner gelber Niederschlag aus der Reaktionslösung aus. Nach Abkühlen wurde das Polymer durch Filtration isoliert. Nach Trocknen wurden 10.92 g (65%) des Polymeren V2 als gelbes Pulver erhalten. Das Polymer war in allen Lösungsmitteln auch in der Wärme unlöslich, daher konnte kein NMR Spektrum aufgenommen werden und es konnten weder GPC-, noch Elektrolumineszenz Daten erhalten werden.

### Beispiel V3

Copolymer aus 50% 3,3"-Bis(methoxy)-2',5'-dichlormethyl-p-terphenyl (E5) und 50% 2,5-Bis(chlormethyl)-1-(3,7-dimethyloctyloxy)-4-methoxy-benzol (Polymer V3):
Herstellung von Poly(2,5-bis[3-methoxyphenyl]-p-phenylenvinylen)co((2-(3,7-dimethyloctyloxy)-5-methoxy-phenyl)-p-phenylenvinylen).

Die Polymerisationsreaktion erfolgte analog zu Beispiel P1 in WO99/24526 unter Verwendung von 11.02 g (28.5 mmol) 3,3"-Bis(methoxy)-2',5'-bis(chlormethyl)-p-terphenyl (E5) und 10.29 g (28.5 mmol) 2,5-Dichlormethyl-1-(3,7-dimethyloctyloxy)-4-methoxybenzol (siehe WO99/24526, Beispiel Z1 c) mit insgesamt 284 ml 1M KOtBu in insgesamt 3.45 L 1,4-Dioxan umgesetzt. Das Polymer fiel spontan als feiner oranger Niederschlag aus der Reaktionslösung aus. Nach Abkühlen wurde das Polymer durch Filtration isoliert. Nach Trocknen wurden 12.33 g (72%) des Polymeren V3 als oranges Pulver erhalten. Das Polymer war in allen Lösungsmitteln auch in der Wärme unlöslich, daher konnte kein NMR Spektrum aufgenommen werden und es konnten weder GPC-, noch Elektrolumineszenz Daten erhalten werden.

### Teil 3: Herstellung und Charakterisierung von LEDs:

Die Herstellung von LEDs erfolgte nach dem im folgenden skizzierten allgemeinen Verfahren. Dieses mußte natürlich im Einzelfall auf die jeweiligen Gegebenheiten (z. B. Polymerviskosität und optimale Schichtdicke des Polymers im Device) angepaßt werden. Die im nachfolgenden beschriebenen LEDs waren jeweils Einschichtsysteme, d. h. Substrat//ITO//Polymer//Kathode.

Allgemeines Verfahren zur Herstellung von hocheffizienten, langlebigen LEDs:

Nachdem man die ITO-beschichteten Substrate (z. B. Glasträger, PET-Folie) auf die richtige Größe zugeschnitten hat, werden sie in mehreren Reinigungsschritten im Ultraschallbad gereinigt (z. B. Seifenlösung, Millipore-Wasser, Isopropanol).
Zur Trocknung werden sie mit einer N2-Pistole abgepustet und in einem Exsikkator gelagert. Vor der Beschichtung mit dem Polymer werden sie mit einem Ozon-Plasma-Gerät für ca. 20 Minuten behandelt. Von dem jeweiligen Polymer wird eine Lösung (in der Regel mit einer Konzentration von 4-25 mg/ml in beispielsweise Toluol, Chlorbenzol, Xylol:Cyclohexanon (4:1)) angesetzt und durch Rühren bei Raumtemperatur gelöst. Je nach Polymer kann es auch vorteilhaft sein, für einige Zeit bei 50 - 70°C zu rühren. Hat sich das Polymer vollständig gelöst, wird es durch einen 5µm Filter filtriert und bei variablen Geschwindigkeiten (400-6000) mit einem Spin-coater aufgeschleudert. Die Schichtdicken können dadurch im Bereich von ca. 50 und 300nm vaniert werden.
Auf die Polymerfilme werden noch Elektroden aufgebracht. Dies geschieht in der Regel durch thermisches Verdampfen (Balzer BA360 bzw. Pfeiffer PL S 500). Anschließend wird die durchsichtige ITO-Elektrode als Anode und die Metallelektrode (z. B. Ca) als Kathode kontaktiert und die Device-Parameter bestimmt.

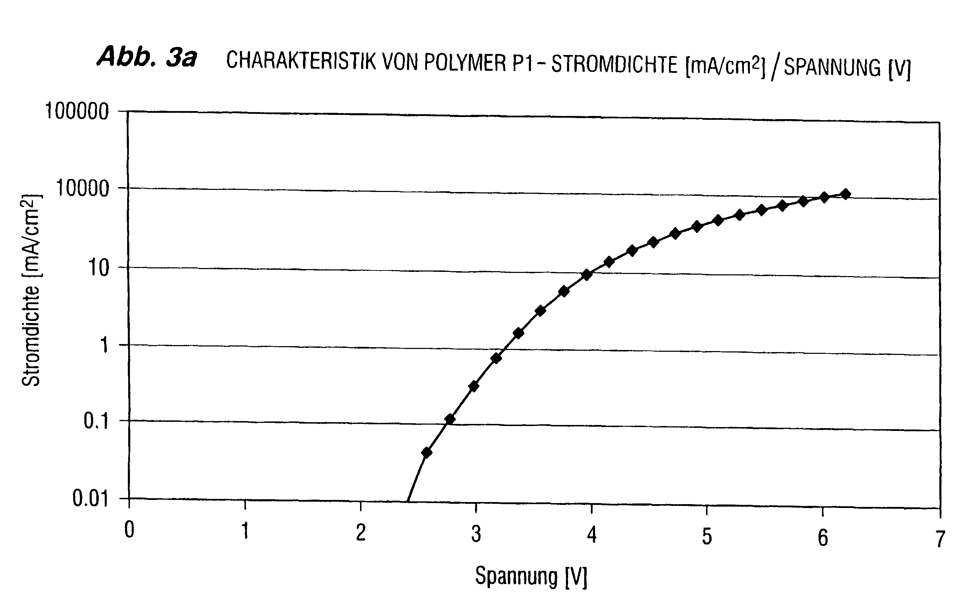

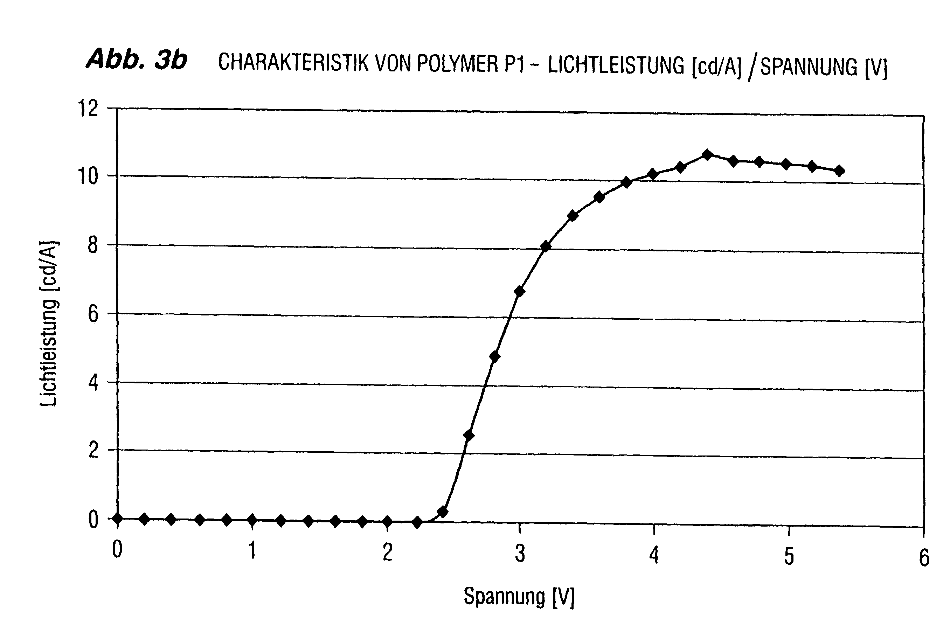

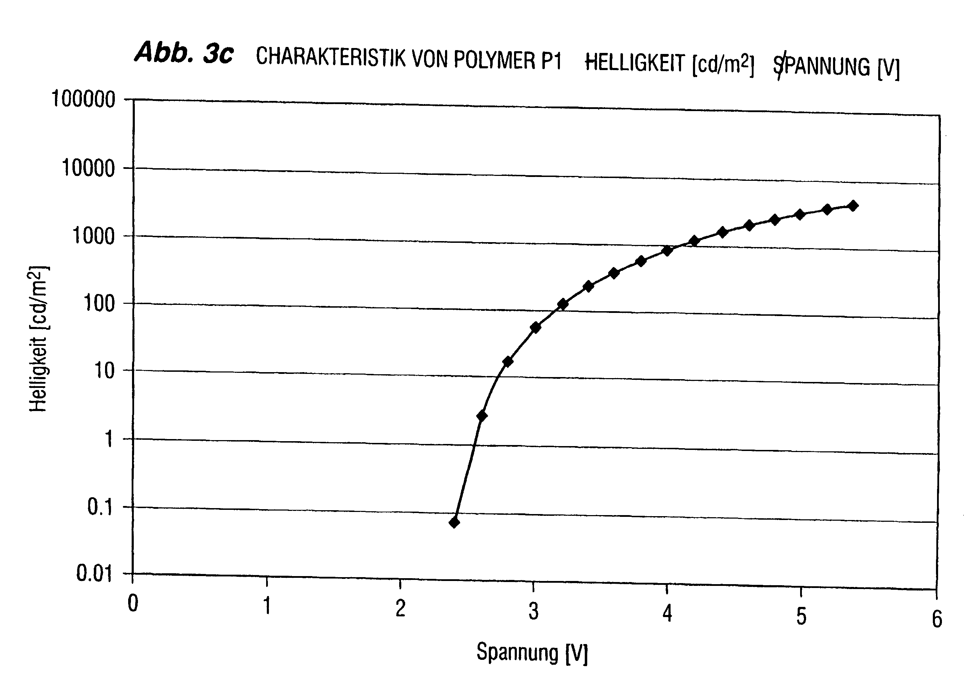

Die mit den beschriebenen Polymeren erhaltenen Resultate sind in den Tabellen 1 und 2 zusammengefaßt. Für Polymer P1 ist in Abbildung 3 noch die typische IVL-Charakteristik in einer Test-Polymer-LED dargestellt.

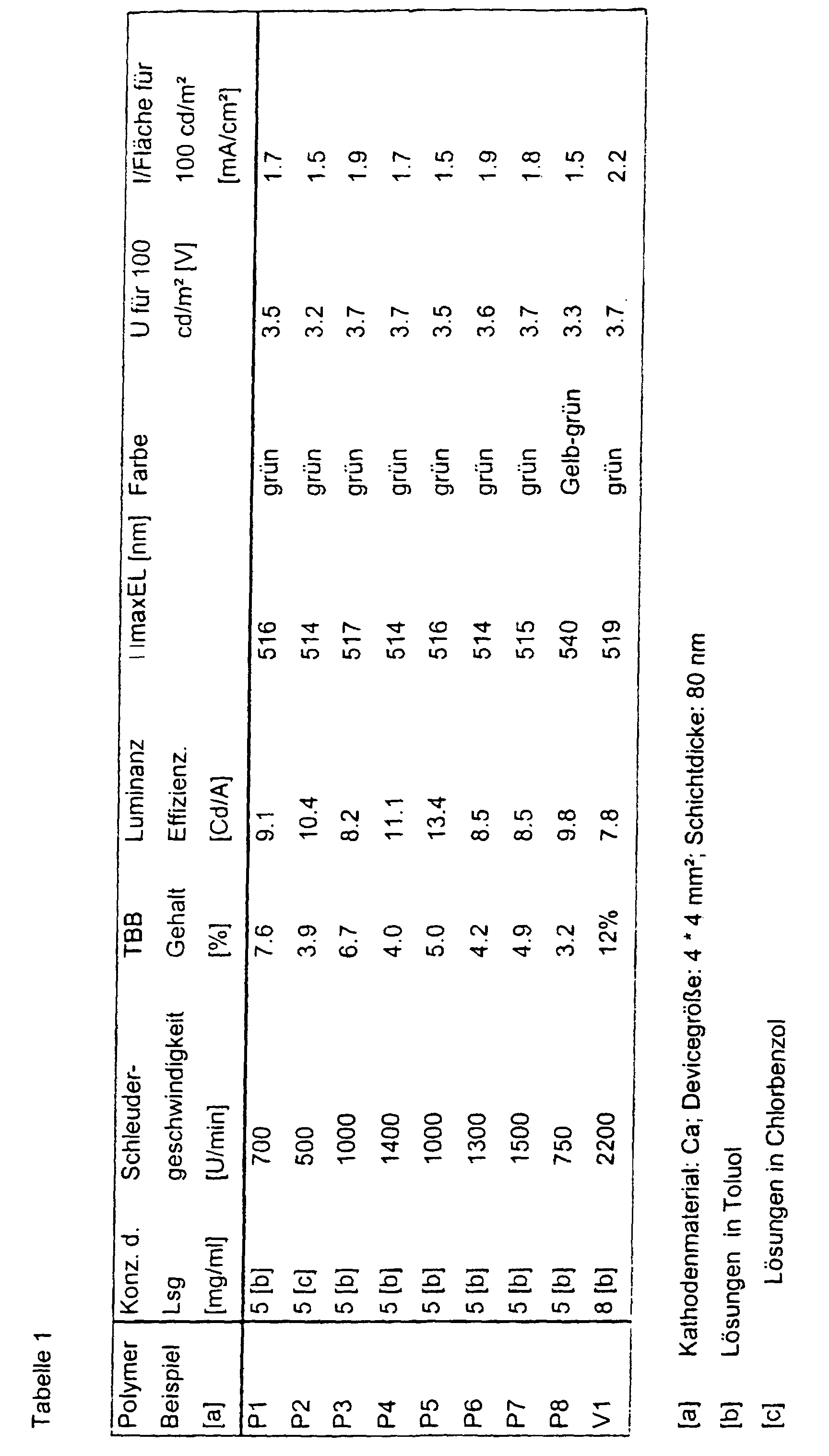

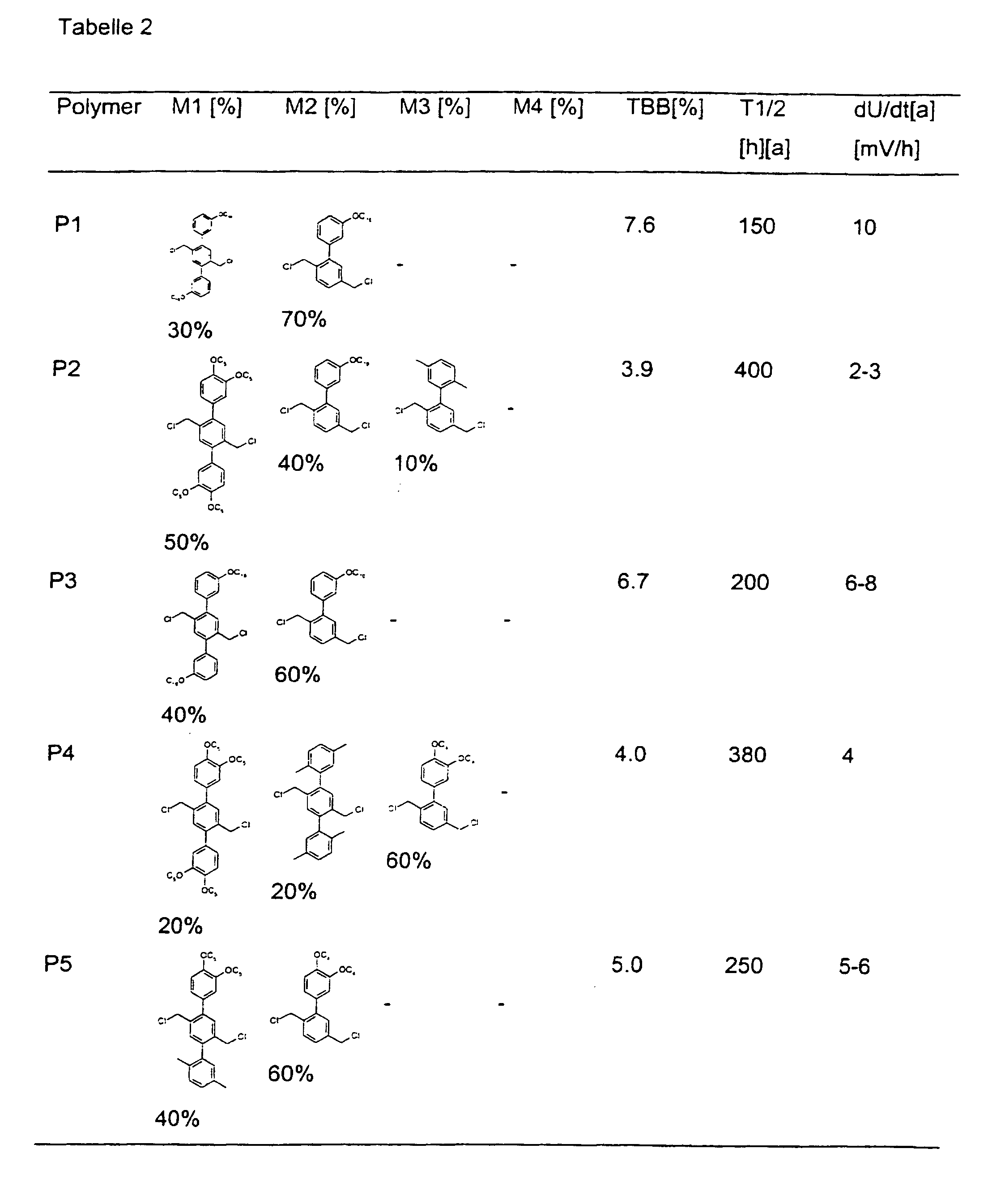

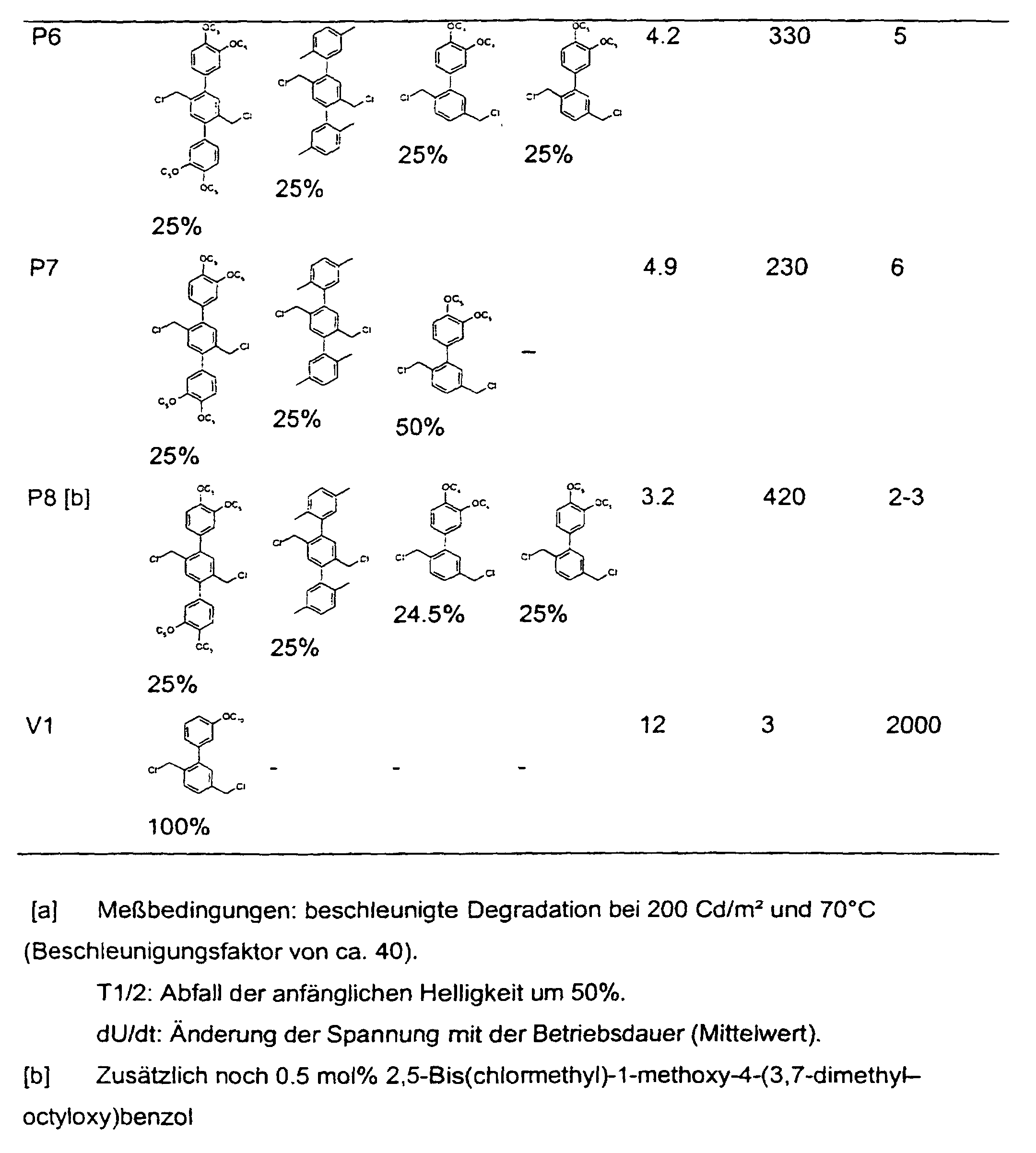

Aus dem Vergleich der Beispiele P mit den Beispielen V ist leicht ableitbar, daß die Löslichkeit der Polymere sehr stark durch die gewählte Komposition beeinflußt wird. Gerade Polymere gemäß den Beschreibungen nach Stand der Technik erweisen sich als nicht verarbeitbar bzw. unlöslich im Sinne diesen Textes.

Die Tabellen 1 und vor allem 2 belegen, daß die erfindungsgemäßen Polymere exzellent für den Einsatz in PLEDs geeignet sind und gerade hinsichtlich der operativen Stabilität bei erhöhten Temperaturen deutliche Vorteile gegenüber bekannten Verbindungen aufweisen.

## Patentansprüche

1. Poly(arylenvinylene), enthaltend mindestens 25 Mol-% einer oder mehrerer Wiederholeinheiten der Formel (I), 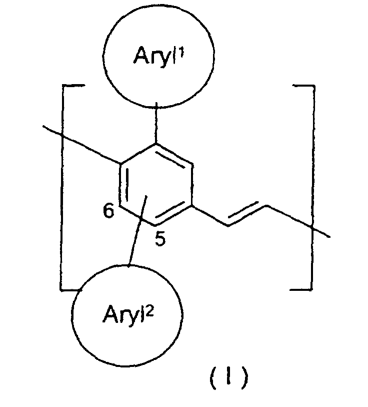 wobei die Symbole und Indizes folgende Bedeutungen haben:
Aryl¹, Aryl²: sind Aryl- bzw. Heteroarylgruppen mit 4 bis 14 C-Atomen, die jeweils wiederum mit 1 bis 5 Substituenten vom Typ R' substituiert sein können;
R' ist, gleich oder verschieden bei jedem Auftreten, CN, F, Cl oder eine geradkettige, verzweigte oder cyclische Alkyl- oder Alkoxygruppe mit 1 bis 20 C-Atomen. wobei ein oder mehrere nicht benachbarte CH₂-Gruppen durch -O-, -S-, -CO-, -COO-, -O-CO-, -NR¹-, -(NR²R³)⁺-A⁻, oder -CONR⁴- ersetzt sein können und wobei ein oder mehrere H-Atome durch F ersetzt sein können, oder eine Aryl- oder Heteroarylgruppe mit 4 bis 14 C-Atome, die durch einen oder mehrere, nicht aromatische Reste R' substituiert sein kann;
R¹,R²,R³,R⁴ sind gleich oder verschieden, H oder ein aliphatischer oder aromatischer Kohlenwasserstoffrest mit 1 bis 20 C-Atomen;
A⁻ . ein einfach geladenes Anion oder dessen Äquivalent;
**dadurch gekennzeichnet, daß** das Polymer löslich ist; mit der Maßgabe, daß die beiden Arylgruppen Aryl¹ und Aryl² derart mit R' Substituenten substituiert sind, daß die Gesamtzahl der in den verschiedenen oder gleichen Substituenten R' enthaltenen nichtaromatischen C-Atome mindestens 4 ist,
und zugleich entweder der Gesamtanteil an Wiederholeinheiten (I) 50mol% nicht übersteigt, oder mindestens 5mol% einer ausgewälten, sperrigen, die Löslichkeit deutlich erhöhenden Wiederholeinheit vom Typ (II) oder (III) 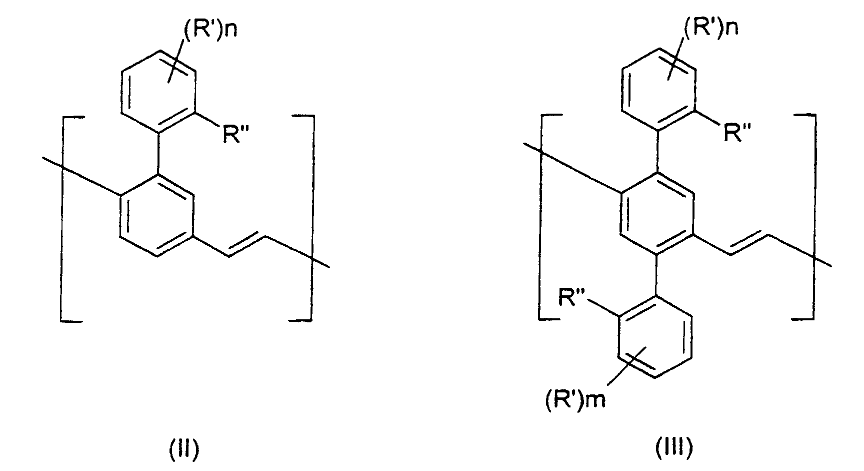 enthalten ist, wobei
R" : ist gleich oder verschieden, eine geradkettige, verzweigte oder cyclische C₁-C₆ Alkyl- oder Alkoxygruppe, wobei ein oder mehrere nicht benachbarte CH₂-Gruppen durch -O-, -S-, -CO-, -COO-, -O-CO-, -NR¹-, -(NR²R³)⁺-A⁻, oder -CONR⁴- ersetzt sein können und wobei ein oder mehrere H-Atome durch F ersetzt sein können, oder eine Aryl- oder Heteroarylgruppe mit 4 bis 12 C-Atome, die durch einen oder mehrere, nicht aromatische Reste R" substituiert sein kann;
n, m : gleich oder verschieden 0, 1, 2, 3, 4 ist;
die übrigen Reste die vorstehende Bedeutung haben,
mit der Maßgabe, das wenn die Wiederholeinheit der Formel (I) auch 2,5-Bis-(4-substituierte phenyl)-phenylen-vinylen-Strukturelemente enthält deren Summe 20 Mol% nicht übersteigt.

2. Poly(arylenvinylene) gemäß Anspruch 1, **dadurch gekennzeichnet, daß** R" gleich oder verschieden Phenyl oder C₁-C₆-Alkyl ist.

3. Poly(arylenvinylene) gemäß Anspruch 2, **dadurch gekennzeichnet, daß** R" gleich oder verschieden Methyl ist.

4. Poly(arylenvinylene) gemäß einem der Ansprüche 1 bis 3, **dadurch gekennzeichnet, daß** es ein Copolymer, bestehend aus Wiederholeinheiten der Formel (I) und Wiederholeinheiten, die unsubstiuierte und/oder substituierte Poly(arylenvinylene)-Strukturen aufweisen, vorzugsweise solche, die eine 2,5-Dialkoxy-1,4-phenylenvinylenstruktur und/oder eine 2-Aryl-1,4-arylenvinylenstruktur aufweisen.

5. Poly(arylenvinylene) gemäß einem der Ansprüche 1 bis 4, **dadurch gekennzeichnet, daß** es sich um ein Copolymer handelt, daß 1, 2 oder 3 verschiedene, Wiederholeinheiten der Formel (I) aufweist.

6. Poly(arylenvinylene) gemäß einem der Ansprüche 1 bis 5, **dadurch gekennzeichnet, daß** es sich bei dem Copolymer um ein statistisches, alternierendes, reguläre und/oder blockartiges Copolymer handelt.

7. Poly(arylenvinylene) gemäß einem der Ansprüche 1 bis 6, **dadurch gekennzeichnet, daß** es
Aryl¹, Aryl² gleich oder verschieden Phenyl, 1- oder 2-Naphthyl, 1-, 2- oder 9-Anthracenyl, 2-, 3- oder 4-Pyridinyl, 2-, 4- oder 5-Pyrimidinyl, 2-Pyrazinyl, 3- oder 4-Pyridazinyl, 2-, 3-, 4-, 5-, 6-, 7- oder 8-Chinolin, 2- oder 3-Thiophenyl, 2- oder. 3-Pyrrolyl, 2- oder 3-Furanyl und 2-(1,3,4-Oxadiazol)yl ist.

8. Poly(arylenvinylene) gemäß Anspruch 7, **dadurch gekennzeichnet, daß** Aryl¹, Aryl² gleich oder verschieden ist und Phenyl, 1-Naphthyl, 2-Naphthyl oder 9-Anthracenyl ist.

9. Poly(arylenvinylene) gemäß einem der Ansprüche 1 bis 6, **dadurch gekennzeichnet, daß** die Arylsubstituenten Aryl¹, Aryl² das Substitutionsmuster 2-, 3-bzw. 4-Alkyl(oxy)phenyl, 2,3-, 2,4-, 2,5-, 2,6-, 3,4- oder 3,5-Dialkyl(oxy)phenyl, 2,3,4,-, 2,3,5-, 2,3,6-, 2,4,5, 2,4,6- oder 3,4,5-Trialkyl(oxy)phenyl, 2-, 3-, 4-, 5-, 6-, 7-oder 8-Alkyl(oxy)-1-naphthyl, 1-, 3-, 4-, 5-, 6-, 7- oder 8-Alkyl(oxy)-2-naphthyl und 10-Alkyl(oxy)-9-anthracenyl aufweisen.

10. Poly(arylenvinylene) gemäß einem der Ansprüche 1 bis 9, **dadurch gekennzeichnet, daß** sie mindestens 30 Mol-% Wiederholeinheiten der Formel (I) enthalten.

11. Poly(arylenvinylene) gemäß einem der Ansprüche 1 bis 10, **dadurch gekennzeichnet, daß** die beiden Arylgruppen Aryl¹ und Aryl² in Formel (I) voneinander verschieden sind.

12. Poly(arylenvinylene) gemäß einem der Ansprüche 1 bis 11, **dadurch gekennzeichnet, daß** die Polymere 10 bis 10000, vorzugsweise 20 bis 5000, besonders bevorzugt 100 bis 5000, ganz besonders bevorzugt 250 bis 2000 Wiederholeinheiten aufweisen.

13. Verwendung der Poly(arylenvinylene) gemäß einem der Ansprüche 1 bis 11, zur Herstellung von Elektrolumineszenz-Vorrichtungen

14. Elektrolumineszenz-Vorrichtung enthaltend Kathode, Anode sowie eine oder mehrere aktive Schichten, wobei mindestens eine dieser aktiven Schichten ein oder mehrere Poly(arylenvinylene) gemäß einem der Ansprüche 1 bis 11 enthält.

## Claims

1. Poly(arylenevinylene) comprising at least 25 mol% of one or more repeating units of the formula (I), 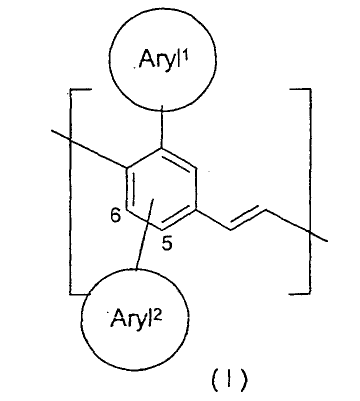 where the symbols and indices have the following meanings:
Aryl¹, Aryl² are aryl or heteroaryl groups which have from 4 to 14 carbon atoms and may in each case be substituted by from 1 to 5 substituents of the type R';
R' is, identical or different at each occurrence, CN, F, Cl or a straight-chain, branched or cyclic alkyl or alkoxy group having from 1 to 20 carbon atoms, where one or more nonadjacent CH₂ groups may be replaced by -O-, -S-, -CO-, -COO-, -O-CO-, -NR¹-, -(NR²R³)⁺-A⁻ or -CONR⁴- and one or more H atoms can be replaced by F, or an aryl or heteroaryl group which has from 4 to 14 carbon atoms and may be replaced by one or more nonaromatic radicals R';
R¹,R²,R³,R⁴ are identical or different and are each H or an aliphatic or aromatic hydrocarbon radical having from 1 to 20 carbon atoms;
A⁻ is a singly charged anion or its equivalent;
**characterized in that** the polymer is soluble; with the proviso that the two aryl groups Aryl¹ and Aryl² are substituted by R' substituents in such a way that the total number of nonaromatic carbon atoms present in the identical or different substituents R' is at least 4,
and at the same time either the total proportion of repeating units (I) does not exceed 50 mol% or at least 5 mol% of a selected, bulky repeating unit of the type (II) or (III) 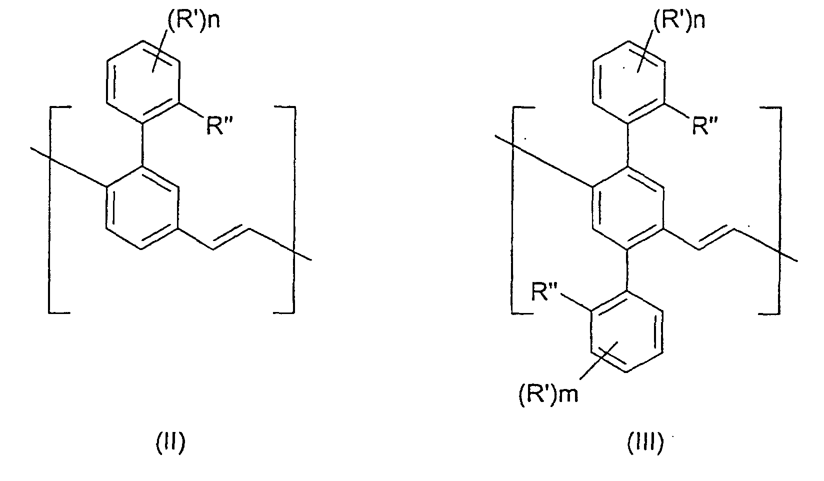 which significantly increases the solubility are present, where
R" are identical or different and are each a straight-chain, branched or cyclic C₁-C₆-alkyl or alkoxy group, where one or more nonadjacent CH₂ groups may be replaced by -O-, -S-, -CO-, -COO-, -O-CO-, -NR¹-, -(NR²R³)⁺-A⁻ or -CONR⁴- and one or more H atoms may be replaced by F or an aryl or heteroaryl group which has from 4 to 12 carbon atoms and may be substituted by one or more nonaromatic radicals R";
n, m are identical or different and are each 0, 1, 2, 3, 4;
and the other radicals are as defined above,
with the proviso that when the repeating unit of the formula (I) also contains 2,5-bis(4-substituted phenyl)phenylenevinylene structural elements, their total does not exceed 20 mol%.

2. A poly(arylenevinylene) as claimed in claim 1, **characterized in that** R" are identical or different and are each phenyl or C₁-C₆-alkyl.

3. A poly(arylenevinylene) as claimed in claim 2, **characterized in that** R" are each methyl.

4. A poly(arylenevinylene) as claimed in any of claims 1 to 3, **characterized in that** it comprises a copolymer comprising repeating units of the formula (I) and repeating units containing unsubstituted and/or substituted poly(arylenevinylene) structures, preferably ones containing a 2,5-dialkoxy-1,4-phenylenevinylene structure and/or a 2-aryl-1,4-arylenevinylene structure.

5. A poly(arylenevinylene) as claimed in any of claims 1 to 4, **characterized in that** it is a copolymer comprising 1, 2 or 3 different repeating units of the formula (I).

6. A poly(arylenevinylene) as claimed in any of claims 1 to 5, **characterized in that** the copolymer is a random, alternating, regular and/or block-like copolymer.

7. A poly(arylenevinylene) as claimed in any of claims 1 to 6, **characterized in that**
Aryl¹, Aryl² are identical or different and are each phenyl, 1- or 2-naphthyl, 1-, 2- or 9-anthracenyl, 2-, 3- or 4-pyridinyl, 2-, 4- or 5-pyrimidinyl, 2-pyrazinyl, 3- or 4-pyridazinyl, 2-, 3-, 4-, 5-, 6-, 7- or 8-quinoline, 2- or 3-thiophenyl, 2- or 3-pyrrolyl, 2- or 3-furanyl or 2-(1,3,4-oxadiazol)yl.

8. A poly(arylenevinylene) as claimed in claim 7, **characterized in that** Aryl¹, Aryl² are identical or different and are each phenyl, 1-naphthyl, 2-naphthyl or 9-anthracenyl.

9. A poly(arylenevinylene) as claimed in any of claims 1 to 6, **characterized in that** the aryl substituents Aryl¹, Aryl² have the substitution pattern 2-, 3- or 4-alkyl(oxy)phenyl, 2,3-, 2,4-, 2,5-, 2,6-, 3,4- or 3,5-dialkyl(oxy)phenyl, 2,3,4,-, 2,3,5-, 2,3,6-, 2,4,5-, 2,4,6- or 3,4,5-trialkyl(oxy)phenyl, 2-, 3-, 4-, 5-, 6-, 7- or 8-alkyl(oxy)-1-naphthyl, 1-, 3-, 4-, 5-, 6-, 7- or 8-alkyl(oxy)-2-naphthyl and 10-alkyl(oxy)-9-anthracenyl.

10. A poly(arylenevinylene) as claimed in any of claims 1 to 9, **characterized in that** it contains at least 30 mol% of repeating units of the formula (I).

11. A poly(arylenevinylene) as claimed in any of claims 1 to 10, **characterized in that** the two aryl groups Aryl¹ and Aryl² in formula (I) are different from one another.

12. A poly(arylenevinylene) as claimed in any of claims 1 to 11, **characterized in that** the polymer is made up of from 10 to 10 000, preferably from 20 to 5 000, particularly preferably from 100 to 5 000, very particularly preferably from 250 to 2 000, repeating units.

13. The use of a poly(arylenevinylene) as claimed in any of claims 1 to 11 for producing electroluminescent devices.

14. An electroluminescent device comprising a cathode, an anode and one or more active layers, where at least one of these active layers comprises one or more poly(arylenevinylenes) as claimed in any of claims 1 to 11.

## Revendications

1. Poly(arylène-vinylènes), contenant au moins 25 % en moles d'un ou plusieurs motifs répétés de formule (I), 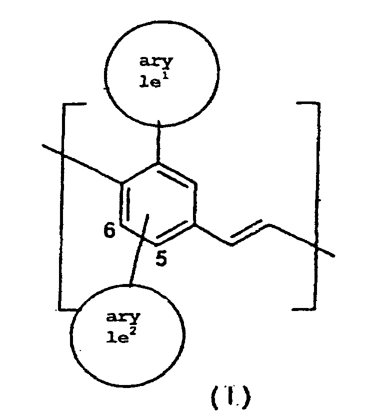 dans laquelle les symboles et les indices ont les significations suivantes :
aryle¹, aryle²: sont des groupes aryle ou hétéroaryle de 4 à 14 atomes de carbone, qui peuvent chacun être à leur tour substitués par 1 à 5 substituants de type R' ;
R' : représente, identique ou différent, pour chaque apparition, CN, F, C1 ou un groupe alkyle ou alcoxy à chaîne linéaire, ramifié ou cyclique de 1 à 20 atomes de carbone, un ou plusieurs groupes CH₂ non adjacents pouvant être remplacés par -O-, -S-, -CO-, -COO-, -O-CO-, -NR¹-, -(NR²R³)⁺-A⁻, ou -CONR⁴- et un ou plusieurs atomes d'hydrogène pouvant être remplacés par F, ou un groupe aryle ou hétéroaryle de 4 à 14 atomes de carbone, qui peut être remplacé par un ou plusieurs restes R' non aromatiques ;
R¹, R², R³, R⁴, identiques ou différents, représentent H ou un reste hydrocarboné aliphatique ou arylique de 1 à 20 atomes de carbone ;
A⁻ : un anion chargé simplement ou son équivalent ;
**caractérisés en ce que** le polymère est soluble ; à condition que les deux groupes aryle aryle¹ et aryle² soient substitués par des substituants R', de sorte que le nombre total d'atomes de carbone non aromatiques contenus dans des substituants R' identiques ou différents vaille au moins 4, et parallèlement que la part totale des motifs répétés (I) ne dépasse pas 50 % en moles, ou au moins 5 % en moles d'un motif répété de type (II) ou (III) choisi, encombrant, qui augmente sensiblement la solubilité, 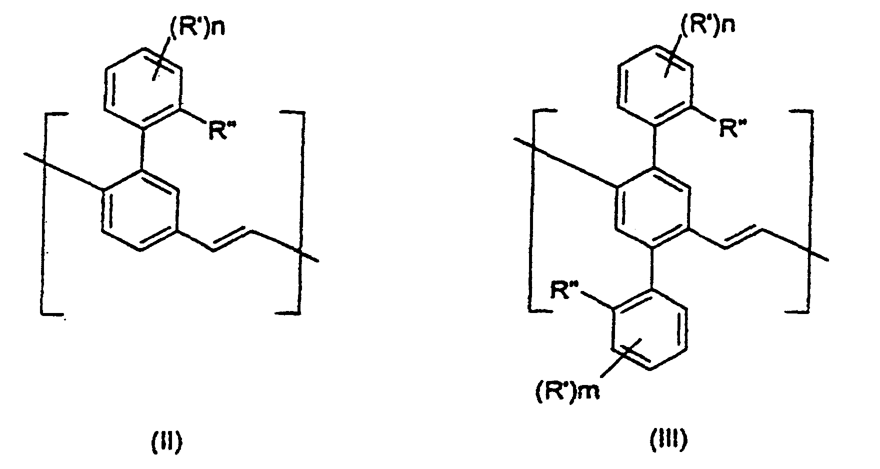 où :
R'' : représente, identique ou différent, un groupe alkyle ou alcoxy en C₁-C₆ à chaîne linéaire, ramifié ou cyclique, un ou plusieurs groupes CH₂ non adjacents pouvant être remplacés par -O-, -S-, -CO-, -COO-, -O-CO-, -NR¹-, -(NR²R³)⁺-A⁻, ou -CONR⁴- et un ou plusieurs atomes d'hydrogène pouvant être remplacés par F, ou un groupe aryle ou hétéroaryle de 4 à 12 atomes de carbone, qui peut être substitué par un ou plusieurs restes R'' non aromatiques ;
n, m : valent, identiques ou différents, 0, 1, 2, 3, 4 ;
les restes restants ont la signification précédente,
à condition que lorsque le motif répété de formule (I) contienne également des éléments de structure 2,5-bis-(4-phényle substitué)-phénylène-vinylène, dont la somme ne dépasse pas 20 % en moles.

2. Poly(arylène-vinylènes) selon la revendication 1, **caractérisés en ce que** R'', identique ou différent, représente un groupe phényle ou un groupe alkyle en C₁-C₆.

3. Poly(arylène-vinylènes) selon la revendication 2, **caractérisés en ce que** R'' identique ou différent représente un groupe méthyle.

4. Poly(arylène-vinylènes) selon l'une quelconque des revendications 1 à 3, **caractérisés en ce qu'**il s'agit d'un copolymère, composé de motifs répétés de formule (I) et de motifs répétés qui présentent des structures de poly(arylène-vinylènes) non substitués et/ou substitués, de préférence ceux qui présentent une structure 2,5-dialcoxy-1,4-phénylène-vinylène et/ou une structure 2-aryl-1,4-arylène-vinylène.

5. Poly(arylène-vinylènes) selon l'une quelconque des revendications 1 à 4, **caractérisés en ce qu'**il s'agit d'un copolymère, qui présente 1, 2 ou 3 motifs répétés différents de formule (I).

6. Poly(arylène-vinylènes) selon l'une quelconque des revendications 1 à 5, **caractérisés en ce qu'**il s'agit pour le copolymère d'un copolymère statistique, formé par alternance, régulier et/ou de type séquencé en blocs.

7. Poly(arylène-vinylènes) selon l'une quelconque des revendications 1 à 6, **caractérisés en ce que**
aryle¹, aryle², identiques ou différents, représentent un groupe phényle, un groupe 1- ou 2-naphtyle , un groupe 1-, 2- ou 9-anthracényle , un groupe 2-, 3- ou 4-pyridinyle , un groupe 2-, 4- ou 5-pyrimidinyle , un groupe 3- ou 4-pyridazinyle, un groupe 2-, 3-, 4-, 5-, 6-, 7- ou 8-quinoléine, un groupe 2- ou 3-thiophényle, un groupe 2- ou 3-pyrrolyle, un groupe 2-ou 3-furanyle et un groupe 2-(1,3,4-oxadiazol)yle.

8. Poly(arylène-vinylènes) selon la revendication 7, **caractérisés en ce que** aryle¹, aryle², sont identiques ou différents et représentent un groupe phényle, un groupe 1-naphtyle, un groupe 2-naphtyle ou un groupe 9-anthracényle.

9. Poly(arylène-vinylènes) selon l'une quelconque des revendications 1 à 6, **caractérisés en ce que** les substituants aryle aryle¹, aryle², présentent le modèle de substitution 2-, 3- ou 4-alkyl(oxy)phényle, 2,3-, 2,4-, 2,5-, 2,6-, 3,4- ou 3,5-dialkyl(oxy)phényle, 2,3,4-, 2,3,5-, 2,3,6-, 2,4,5-, 2,4,6-, ou 3,4,5-trialkyl(oxy)phényle, 2-,3-,4-,5-,6-,7- ou 8-alkyl(oxy)-1-naphtyle, 1-,3-,4-,5-,6-,7- ou 8-alkyl(oxy)-2-naphtyle et 10-alkyl(oxy)-9-anthracényle.

10. Poly(arylène-vinylènes) selon l'une quelconque des revendications 1 à 9, **caractérisés en ce qu'**ils comprennent au moins 30 % en moles de motif répétés de formule (I).

11. Poly(arylène-vinylènes) selon l'une quelconque des revendications 1 à 10, **caractérisés en ce que** les deux groupes aryle aryle¹ et aryle² de formule (I) sont différents l'un de l'autre.

12. Poly(arylène-vinylènes) selon l'une quelconque des revendications 1 à 11, **caractérisés en ce que** les polymères présentent 10 à 10000, de préférence de 20 à 5000, plus préférablement de 100 à 5000, de manière préférée entre toutes de 250 à 2000 motifs répétés.

13. Utilisation des poly(arylène-vinylènes) selon l'une quelconque des revendications 1 à 11, pour fabriquer des dispositifs électroluminescents.

14. Dispositif électroluminescent contenant une cathode, une anode, ainsi qu'une ou plusieurs couches actives, au moins une de ces couches actives contenant un ou plusieurs poly(arylène-vinylènes) selon l'une quelconque des revendications 1 à 11.
